# EUROPEAN PATENT APPLICATION

(11) **EP 3 703 146 A1**
(43) Date of publication of application: **02.09.2020**
(21) Application number: 18871468.7
(22) Date of filing: 17.10.2018
(51) Int. Cl.: H01L 51/50, C08G 61/10, C08G 61/12, C08K 3/36, C08L 65/00

(54) **LIGHT-EMITTING ELEMENT**

(30) Priority: 27.10.2017 JP 2017208611
(71) Applicant: Sumitomo Chemical Company, Limited, Tokyo 104-8260 (JP)
(72) Inventor: IIJIMA, Takayuki, Tsukuba-shi Ibaraki 300-3294 (JP); YAMAMOTO, Kyoko, Tsukuba-shi Ibaraki 300-3294 (JP)
(74) Representative: J A Kemp LLP
(86) International application number: PCT/JP2018/038710
(87) International publication number: WO 2019/082769

(57) **Abstract**

An object to be achieved by the present invention is to provide a light-emitting device with a high current efficiency. The present invention provides a light-emitting device that includes, in sequence, a cathode, an electron transport layer, a light-emitting layer, and an anode, the light-emitting device further optionally including an electron injection layer between the cathode and the electron transport layer, wherein the electron transport layer contains particles and a non-particle electron transport material; a refractive index of light n1 at a wavelength of 550 nm of a material that constitutes the particles and a refractive index of light n2 at a wavelength of 550 nm of the non-particle electron transport material satisfy the following relation: n1-n2≤0.15; and the particles have a Z-average size of 110 to 300 nm as determined by dynamic light scattering.

## Description

### Technical Field

The present invention relates to a light-emitting device.

### Background Art

Light-emitting devices containing an ultrathin film of an organic substance, such as organic light-emitting diodes (OLED) and polymer light-emitting devices (PLED), have been actively studied for applications in lighting equipment, display devices, and other devices. A light-emitting device includes an anode, a cathode, and a light-emitting layer provided between the anode and the cathode. Light emitted from the light-emitting layer passes through a translucent anode (e.g., ITO) or is reflected by the cathode (e.g., aluminum), and then reaches a substrate through the translucent anode, and exits. However, total internal reflection may occur depending on the angle of incident light that enters the interface between adjacent layers that differ in refractive index, and the light becomes guided light that travels while being totally reflected in the plane direction inside the device. The light is absorbed inside the device and attenuated, and thus cannot be taken out. In the case of a typical organic light-emitting diode, the percentage of light that can be extracted to the outside is at most 20%.

An example of techniques to increase light extraction efficiency is a light-emitting device disclosed in PTL 1 that includes a substrate, an anode, a cathode, an electroluminescent layer, and a hole injecting layer that includes 5 to 50 mass% of inorganic nanoparticles having a bimodal particle size distribution of a first population and a second population dispersed in an organic matrix wherein the inorganic nanoparticles have a refractive index of at least 0.1 greater than the refractive index of the organic matrix. PTL 1 also discloses that the inorganic nanoparticles have a particle size of 10 nm to 100 nm.

### Citation List

### Patent Literature

PTL 1: US Patent Application Publication No. 2014/0061592

### Summary of Invention

### Technical Problem

However, traditional light-emitting devices containing particles with a relatively small particle size dispersed in an organic matrix are unsatisfactory in current efficiency.

Thus, an object of the present invention is to provide a light-emitting device with a high current efficiency.

### Solution to Problem

The present invention provides the following Items 1 to 8.
Item 1.
   A light-emitting device comprising, in sequence, a cathode, an electron transport layer, a light-emitting layer, and an anode,
   the light-emitting device further optionally comprising an electron injection layer between the cathode and the electron transport layer,
   wherein
   the electron transport layer contains particles and a non-particle electron transport material,
   a refractive index of light n1 at a wavelength of 550 nm of a material that constitutes the particles and a refractive index of light n2 at a wavelength of 550 nm of the non-particle electron transport material satisfy the following relation: n1-n2≤-0.15, and
   the particles have a Z-average size of 110 to 300 nm as determined by dynamic light scattering.
Item 2.
   The light-emitting device according to Item 1, wherein the refractive index of light n1 at a wavelength of 550 nm of the material that constitutes the particles is 1.5 or less.
Item 3.
   The light-emitting device according to Item 1 or 2, wherein the particles are silica particles.
Item 4.
   The light-emitting device according to any one of Items 1 to 3, wherein the electron transport material contains a polymer compound that has a constitutional unit represented by formula (ET-1): 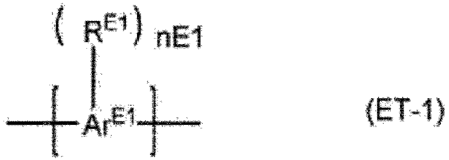
   wherein nE1 represents an integer of 1 or more,
   Ar^{E1} represents an optionally substituted aromatic hydrocarbon group or an optionally substituted heterocyclic group,
   R^{E1} represents an optionally substituted monovalent group containing one or more heteroatoms, and when a plurality of R^{E1}s are present, the plurality of R^{E1}s may be identical or different.
Item 5.
   The light-emitting device according to any one of Items 1 to 4, wherein the electron transport material contains a compound represented by formula (H-1): 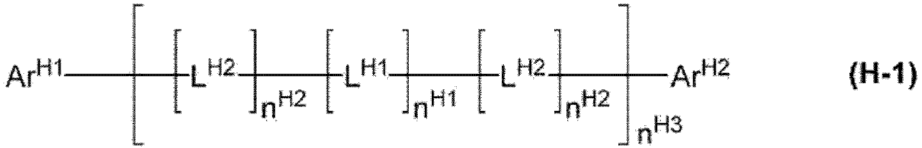
   wherein Ar^{H1} and Ar^{H2} each independently represent an optionally substituted monovalent aromatic hydrocarbon group or an optionally substituted monovalent heterocyclic group,
   L^{H1} represents an optionally substituted divalent aromatic hydrocarbon group or an optionally substituted divalent heterocyclic group,
   L^{H2} represents a group represented by formula: -N (-L^{H21}-R^{H21}) -
      wherein L^{H21} represents a single bond, an optionally substituted arylene group, or an optionally substituted divalent heterocyclic group,
      R^{H21} represents a hydrogen atom, an optionally substituted alkyl group, an optionally substituted cycloalkyl group, an optionally substituted aryl group, or an optionally substituted monovalent heterocyclic group,
   when a plurality of L^{H1}s are present, the plurality of L^{H1}s may be identical or different,
   when a plurality of L^{H2}s are present, the plurality of L^{H2}s may be identical or different, and
   n^{H1}, n^{H2}, and n^{H3} each independently represent an integer of 0 or more and 10 or less.
Item 6.
   The light-emitting device according to any one of Items 1 to 5, wherein the proportion of the particles is 1 to 200 parts by mass relative to 100 parts by mass of the electron transport material.
Item 7.
   The light-emitting device according to any one of Items 1 to 6, wherein the number of the particles per unit area of the electron transport layer is 1/µm² or more.
Item 8.
   The light-emitting device according to any one of Items 1 to 7, wherein the cathode or the electron injection layer is adjacent to the electron transport layer, and an interface between the cathode or the electron injection layer and the electron transport layer has a root mean square roughness of 5 nm or more.

### Advantageous Effects of Invention

The light-emitting device according to the present invention emits light with high efficiency. The high current efficiency of the light-emitting device according to the present invention is thought to be due to improved light extraction efficiency.

### Description of Embodiments

Below, preferred embodiments of the present invention will be described in detail.

### Explanation of Common Terms

The terms used in common throughout this specification have the following meanings unless otherwise specified.

Me represents a methyl group, Et represents an ethyl group, Bu represents a butyl group, i-Pr represents an isopropyl group, t-Bu represents a tert-butyl group, and Ph represents a phenyl group.

The hydrogen atom may be a heavy hydrogen atom or a light hydrogen atom.

In a formula that represents a metal complex, a solid line that represents a bond with the central metal denotes a covalent bond or a coordinate bond.

The "polymer compound" refers to a polymer that has a molecular weight distribution and a polystyrene-equivalent number average molecular weight of 1 × 10³ or more (e.g., 1 × 10³ to 1 × 10⁸). The polymer compound may be a block copolymer, a random copolymer, an alternating copolymer, or a graft copolymer, or may be in other forms.

The terminal group of the polymer compound is preferably a stable group. The reason is that the use of a polymer compound that has remaining polymerizable active groups in preparing a light-emitting device may reduce the luminescence characteristics or luminance lifetime. The terminal group is preferably a group conjugated with the main chain, such as a group bonded to an aryl group or a monovalent heterocyclic group via a carbon-carbon bond.

The "constitutional unit" refers to a unit that is present one or more times in a polymer compound.

The "low-molecular-weight compound" refers to a compound that has no molecular weight distribution, and has a molecular weight of 1×10⁴ or less.

The "alkyl group" may be linear and branched. A linear alkyl group typically has 1 to 50 carbon atoms, preferably 1 to 10 carbon atoms, and more preferably 1 to 6 carbon atoms. A branched alkyl group typically has 3 to 50 carbon atoms, preferably 3 to 30 carbon atoms, and more preferably 4 to 20 carbon atoms. Examples of such alkyl groups include methyl, ethyl, n-propyl, isopropyl, n-butyl, 2-butyl, isobutyl, tert-butyl, n-pentyl, isoamyl, 2-ethylbutyl, n-hexyl, n-heptyl, n-octyl, 2-ethylhexyl, 3-propylheptyl, n-decyl, 3,7-dimethyloctyl, 2-ethyloctyl, 2-hexyldecyl, and n-dodecyl.

Examples of substituted alkyl groups specifically include alkyl groups whose hydrogen atoms are partially or fully (e.g., one to all of the hydrogen atoms that can be replaced) replaced with cycloalkyl, alkoxy, cycloalkoxy, aryl, a fluorine atom, or the like. There is no limitation to the number of substituents of a substituted alkyl group, and the number of substituents is suitably selected from the range of 1 to the possible maximum number of substituents. Specifically, the number of substituents is, for example, 1 to 9, 1 to 5, and 1 to 3. Examples of the "substituted alkyl group" include trifluoromethyl, pentafluoroethyl, perfluorobutyl, perfluorohexyl, perfluorooctyl, 3-phenylpropyl, 3-(4-methylphenyl)propyl, 3-(3,5-di-hexylphenyl)propyl, and 6-ethyloxyhexyl.

Examples of alkylene groups include a divalent group obtained by removing one hydrogen atom from the alkyl group described above.

The "cycloalkyl group" typically has 3 to 50 carbon atoms, preferably 3 to 30 carbon atoms, and more preferably 4 to 20 carbon atoms.

Examples of cycloalkyl groups include cyclopropyl, cyclobutyl, and cyclohexyl.

The "aryl group" refers to an atomic group obtained by removing one hydrogen atom directly bonded to one of the carbon atoms that constitute the ring of an aromatic hydrocarbon. The number of carbon atoms in the aryl group is typically 6 to 60, preferably 6 to 20, and more preferably 6 to 10.

The aryl group may optionally be substituted. Examples of optionally substituted aryl groups include phenyl, 1-naphthyl, 2-naphthyl, 1-anthracenyl, 2-anthracenyl, 9-anthracenyl, 1-pyrenyl, 2-pyrenyl, 4-pyrenyl, 2-fluorenyl, 3-fluorenyl, 4-fluorenyl, 2-phenylphenyl, 3-phenylphenyl, and 4-phenylphenyl. The aryl group may be those obtained by partially or fully replacing the hydrogen atoms (e.g., one to all of the hydrogen atoms that can be replaced) of these aryl groups with alkyl, cycloalkyl, alkoxy, cycloalkoxy, aryl, a fluorine atom, or the like. There is no limitation to the number of substituents of a substituted aryl group, and the number of substituents is suitably selected from the range of 1 to the possible maximum number of substituents (e.g., 1 to 9, 1 to 5, and 1 to 3).

The "alkoxy group" may be linear or branched. A linear alkoxy group typically has 1 to 40 carbon atoms, and preferably 1 to 6 carbon atoms. A branched alkoxy group typically has 3 to 40 carbon atoms, and preferably 4 to 10 carbon atoms.

Examples of alkoxy groups include methoxy, ethoxy, n-propyloxy, isopropyloxy, n-butyloxy, isobutyloxy, tert-butyloxy, n-pentyloxy, n-hexyloxy, n-heptyloxy, n-octyloxy, 2-ethylhexyloxy, n-nonyloxy, n-decyloxy, 3,7-dimethyloctyloxy, and lauryloxy. The alkoxy group may optionally be substituted. The optionally substituted alkoxy group includes those obtained by partially or fully replacing the hydrogen atoms (e.g., one to all of the hydrogen atoms that can be replaced) of these alkoxy groups with cycloalkyl, alkoxy, cycloalkoxy, aryl, a fluorine atom, or the like. There is no limitation to the number of substituents of a substituted alkoxy group, and the number of substituents is suitably selected from the range of 1 to the possible maximum number of substituents. Specifically, the number of substituents is, for example, 1 to 9, 1 to 5, and 1 to 3.

The cycloalkoxy group typically has 3 to 40 carbon atoms, and preferably 4 to 10 carbon atoms. Examples of cycloalkoxy groups include cyclohexyloxy.

The aryloxy group typically has 6 to 60 carbon atoms, and preferably 6 to 48 carbon atoms.

Examples of aryloxy groups include phenoxy, 1-naphthyloxy, 2-naphthyloxy, 1-anthracenyloxy, 9-anthracenyloxy, and 1-pyrenyloxy. The aryloxy group may optionally be substituted. The optionally substituted aryloxy group includes those obtained by partially or fully replacing the hydrogen atoms (e.g., one to all of the hydrogen atoms that can be replaced) of these aryloxy groups with alkyl, cycloalkyl, alkoxy, cycloalkoxy, a fluorine atom, or the like. There is no limitation to the number of substituents of a substituted aryloxy group, and the number of substituents is suitably selected from the range of 1 to the possible maximum number of substituents. Specifically, the number of substituents is, for example, 1 to 9, 1 to 5, and 1 to 3.

The "alkylsulfenyl group" may be linear or branched. A linear alkylsulfenyl group typically has 1 to 40 carbon atoms, and preferably 4 to 10 carbon atoms. A branched alkylsulfenyl group typically has 3 to 40 carbon atoms, and preferably 4 to 10 carbon atoms.

Examples of alkylsulfenyl groups include methylsulfenyl, ethylsulfenyl, propylsulfenyl, isopropylsulfenyl, butylsulfenyl, isobutylsulfenyl, tert-butylsulfenyl, pentylsulfenyl, hexylsulfenyl, heptylsulfenyl, octylsulfenyl, 2-ethylhexylsulfenyl, nonylsulfenyl, decylsulfenyl, 3,7-dimethyloctylsulfenyl, and laurylsulfenyl. The alkylsulfenyl group may optionally be substituted. The optionally substituted alkylsulfenyl group includes those obtained by partially or fully replacing the hydrogen atoms (e.g., one to all of the hydrogen atoms that can be replaced) of these alkylsulfenyl groups with cycloalkyl, alkoxy, cycloalkoxy, aryl, a fluorine atom, or the like. There is no limitation to the number of substituents of a substituted alkylsulfenyl group, and the number of substituents is suitably selected from the range of 1 to the possible maximum number of substituents. Specifically, the number of substituents is, for example, 1 to 9, 1 to 5, and 1 to 3.

The cycloalkylsulfenyl group typically has 3 to 40 carbon atoms, and preferably 4 to 10 carbon atoms. Examples of cycloalkylsulfenyl groups include cyclohexylsulfenyl.

The arylsulfenyl group typically has 6 to 60 carbon atoms, and preferably 7 to 48 carbon atoms.

Examples of arylsulfenyl groups include phenylsulfenyl, 1-naphthylsulfenyl, 2-naphthylsulfenyl, 1-anthracenylsulfenyl, 9-anthracenylsulfenyl, and 1-pyrenylsulfenyl. The arylsulfenyl group may optionally be substituted. The optionally substituted arylsulfenyl group includes those obtained by partially or fully replacing the hydrogen atoms (e.g., one to all of the hydrogen atoms that can be replaced) of these arylsulfenyl groups with alkyl, cycloalkyl, alkoxy, cycloalkoxy, a fluorine atom, or the like. There is no limitation to the number of substituents of a substituted arylsulfenyl group, and the number of substituents is suitably selected from the range of 1 to the possible maximum number of substituents. Specifically, the number of substituents is, for example, 1 to 9, 1 to 5, and 1 to 3.

The "heterocyclic group having a valence of p" (p represents an integer of 1 or more) refers to an atomic group obtained by removing p hydrogen atoms from among the hydrogen atoms directly bonded to the carbon atoms or one or more heteroatoms that constitute the ring of a heterocyclic compound. Of the heterocyclic groups having a valence of p, "aromatic heterocyclic groups having a valence of p" are preferable; the aromatic heterocyclic groups having a valence of p are an atomic group obtained by removing p hydrogen atoms from among the hydrogen atoms directly bonded to the carbon atoms or one or more heteroatoms that constitute the ring of an aromatic heterocyclic compound.

The "aromatic heterocyclic compound" refers to compounds whose heterocyclic ring itself has aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, and dibenzophosphole; and compounds whose heterocyclic ring does not have aromaticity but that have an aromatic ring fused to the heterocyclic ring, such as phenoxazine, phenothiazine, dibenzoborole, dibenzosilole, and benzopyran.

The heterocyclic group having a valence of p typically has 2 to 60 carbon atoms, preferably 3 to 20 carbon atoms, and more preferably 4 to 20 carbon atoms.

Of the heterocyclic groups having a valence of p, examples of monovalent heterocyclic groups include thienyl, pyrrolyl, furyl, pyridyl, piperidinyl, quinolinyl, isoquinolinyl, pyrimidinyl, and triazinyl.

The heterocyclic group having a valence of p may optionally be substituted. The optionally substituted monovalent heterocyclic group includes those obtained by partially or fully replacing the hydrogen atoms (e.g., one to all of the hydrogen atoms that can be replaced) of these heterocyclic groups with alkyl, cycloalkyl, alkoxy, cycloalkoxy, or the like. There is no limitation to the number of substituents of a substituted monovalent heterocyclic group, and the number of substituents is suitably selected from the range of 1 to the possible maximum number of substituents. Specifically, the number of substituents is, for example, 1 to 9, 1 to 5, and 1 to 3.

The "halogen atom" represents a fluorine atom, a chlorine atom, a bromine atom, or an iodine atom.

The "amino group" may optionally be substituted. In the present invention, between an amino group and a substituted amino group, a substituted amino group is preferable. The substituent of the substituted amino group is preferably alkyl, cycloalkyl, aryl, or a monovalent heterocyclic group.

The substituted amino group is preferably a disubstituted amino group. Examples of disubstituted amino groups include dialkylamino, dicycloalkylamino, and diarylamino. The substituents of the disubstituted amino group may be bonded to each other to form a ring. The number of carbon atoms of an alkyl group as a substituent of the disubstituted amino group is preferably 1 to 10, more preferably 1 to 6, and still more preferably 1 to 4.

Examples of disubstituted amino groups include dimethylamino, diethylamino, diphenylamino, bis(4-methylphenyl)amino, bis(4-tert-butylphenyl)amino, and bis(3,5-di-tert-butylphenyl)amino.

The "alkenyl group" may be linear or branched. A linear alkenyl group typically has 2 to 30 carbon atoms, and preferably 3 to 20 carbon atoms. A branched alkenyl group typically has 3 to 30 carbon atoms, and preferably 4 to 20 carbon atoms.

The "cycloalkenyl group" typically has 3 to 30 carbon atoms, and preferably from 4 to 20 carbon atoms.

Examples of alkenyl groups include vinyl, 1-propenyl, 2-propenyl, 2-butenyl, 3-butenyl, 3-pentenyl, 4-pentenyl, 1-hexenyl, 5-hexenyl, and 7-octenyl. The alkenyl group and the cycloalkenyl group may optionally be substituted. The optionally substituted alkenyl group and the optionally substituted cycloalkenyl group include those obtained by partially or fully replacing the hydrogen atoms (e.g., one to all of the hydrogen atoms that can be replaced) of these groups with a substituent. There is no limitation to the number of substituents of a substituted alkenyl group and a substituted cycloalkenyl group, and the number of substituents is suitably selected from the range of 1 to the possible maximum number of substituents. Specifically, the number of substituents is, for example, 1 to 9, 1 to 5, and 1 to 3.

The "alkynyl group" may be linear or branched. The alkynyl group typically has 2 to 20 carbon atoms, and preferably 3 to 20 carbon atoms. A branched alkynyl group typically has 4 to 30 carbon atoms, and preferably 4 to 20 carbon atoms.

A cycloalkynyl group typically has 4 to 30 carbon atoms, and preferably 4 to 20 carbon atoms.

Examples of alkynyl groups include ethynyl, 1-propynyl, 2-propynyl, 2-butynyl, 3-butynyl, 3-pentynyl, 4-pentynyl, 1-hexynyl, and 5-hexynyl. The alkynyl group and cycloalkynyl group may optionally be substituted. For example, substituted alkynyl groups include those obtained by partially or fully replacing the hydrogen atoms (e.g., one to all of the hydrogen atoms that can be replaced) of these groups. There is no limitation to the number of substituents of a substituted alkynyl group and a cycloalkynyl group, and the number of substituents is suitably selected from the range of 1 to the possible maximum number of substituents. Specifically, the number of substituents is, for example, 1 to 9, 1 to 5, and 1 to 3.

A "hydrocarbyl group" refers to a monovalent group obtained by removing one hydrogen atom from a hydrocarbon compound. Examples include the above alkyl group, cycloalkyl group, alkenyl group, cycloalkenyl group, alkynyl group, cycloalkynyl group, aryl group, and combinations of these groups.

Examples of hydrocarbylene groups include a divalent group obtained by removing one hydrogen atom from the hydrocarbyl group described above.

The "arylene group" refers to a remaining atomic group obtained by removing two hydrogen atoms directly bonded to carbon atoms that constitute the ring of an aromatic hydrocarbon. The arylene group typically has 6 to 60 carbon atoms, preferably 6 to 30 carbon atoms, and more preferably 6 to 18 carbon atoms.

Examples of arylene groups include phenylene, naphthalenediyl, anthracenediyl, phenanthrenediyl, dihydrophenanthrenediyl, naphthacenediyl, fluorenediyl, pyrenediyl, perylenediyl, and chrysenediyl. The arylene group may optionally be substituted. Examples of substituted arylene groups include those obtained by partially or fully replacing the hydrogen atoms (e.g., one to all of the hydrogen atoms that can be replaced) of these groups with a substituent. There is no limitation to the number of substituents of a substituted arylene group, and the number of substituents is suitably selected from the range of 1 to the possible maximum number of substituents. Specifically, the number of substituents is, for example, 1 to 9, 1 to 5, and 1 to 3. The optionally substituted arylene group is preferably a group represented by any of formulas (A-1) to (A-20) . 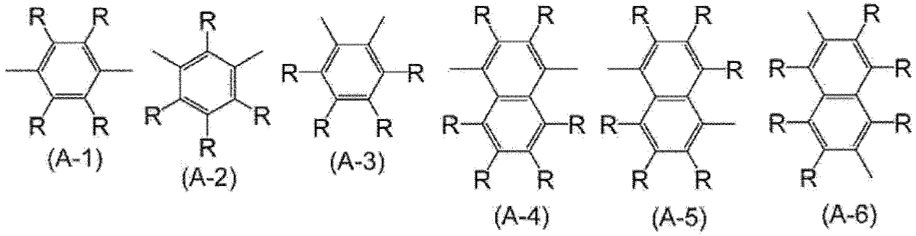 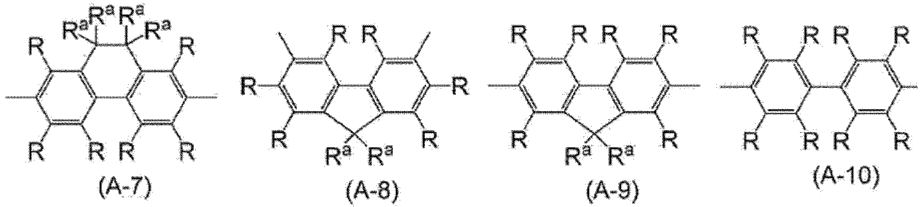 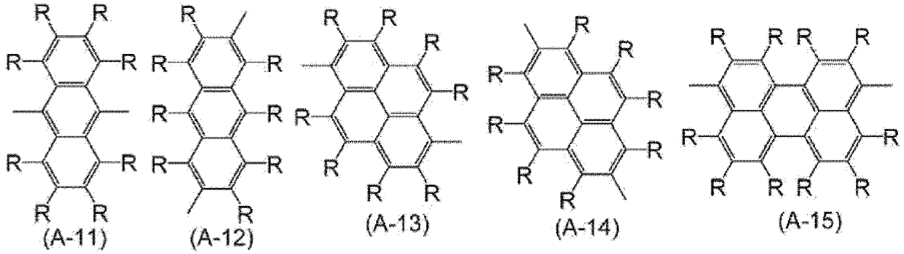 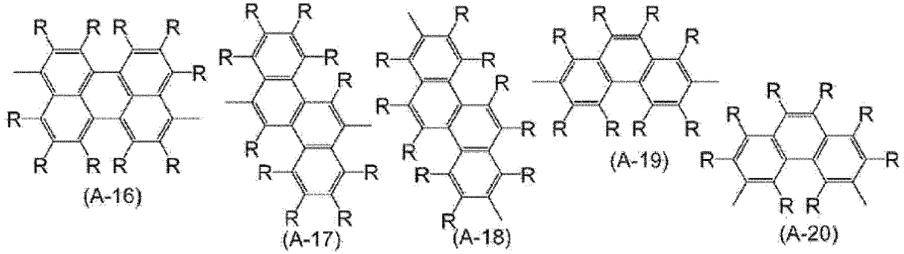 wherein R and R^{a} each independently represent a hydrogen atom, an alkyl group, a cycloalkyl group, an aryl group, or a monovalent heterocyclic group; a plurality of Rs and R^{a}s may be identical or different, and R^{a}s may be bonded to each other to form a ring, taken together with the atom to which each R^{a} is bonded.

The divalent heterocyclic group typically has 2 to 60 carbon atoms, preferably, 3 to 20 carbon atoms, and more preferably, 4 to 15 carbon atoms.

Examples of divalent heterocyclic groups include a divalent group obtained by removing two hydrogen atoms from among the hydrogen atoms directly bonded to carbon atoms or one or more heteroatoms that constitute the ring of pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole, or triazole. The divalent heterocyclic group may optionally be substituted. The optionally substituted divalent heterocyclic group is preferably a group represented by formulas any of (AA-1) to (AA-34). 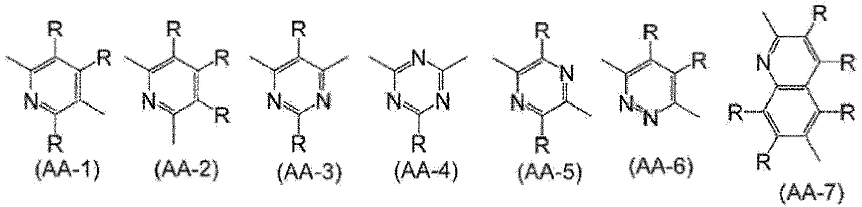 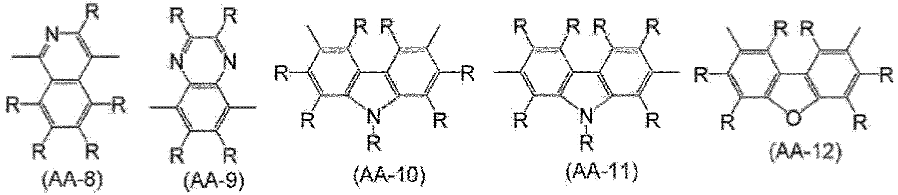 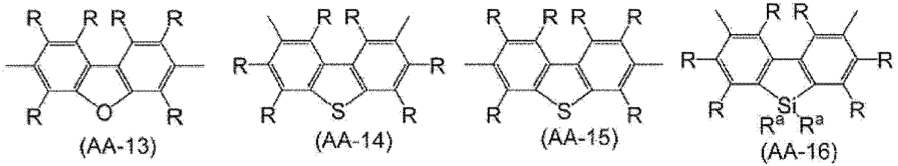 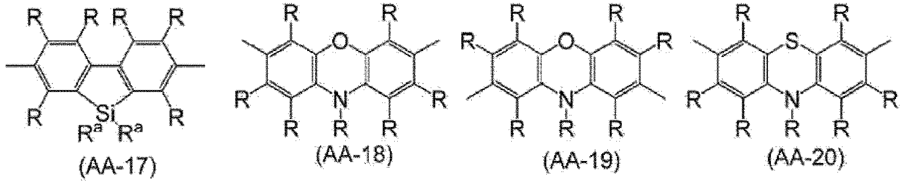 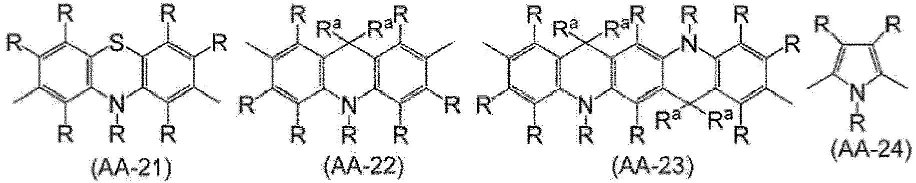 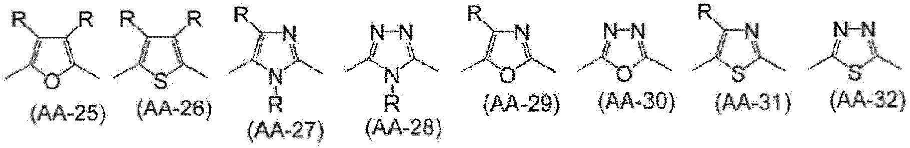 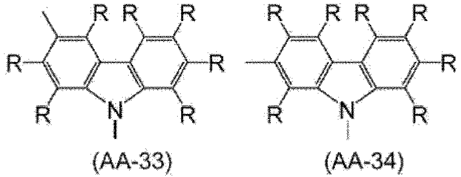 wherein R and R^{a} are as defined above.

The "crosslinkable group" refers to a group capable of generating a new bond when being subjected to heating, ultraviolet irradiation, near ultraviolet irradiation, visible light irradiation, infrared irradiation, radical reaction, or the like. The crosslinkable group is preferably a group represented by any of formulas (B-1) to (B-17). These groups may optionally be substituted.

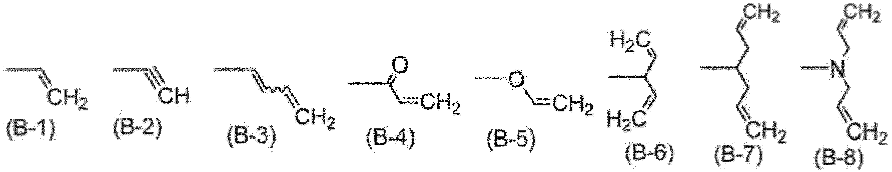

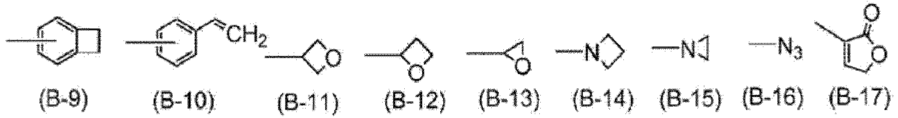

Unless otherwise specified in this specification, the "substituent" represents a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, or a cycloalkynyl group. The substituent may be a crosslinkable group. In the present invention, a substituted group may have any number of substituents, and the number of substituents can be suitably selected from 1 to the possible maximum number of substituents: specifically, the number of substituents is, for example, 1 to 9, 1 to 5, and 1 to 3.

### Light-emitting Device

The light-emitting device according to this embodiment includes an anode, a light-emitting layer, an electron transport layer, and a cathode. The electron transport layer in the light-emitting device according to this embodiment includes particles and a non-particle electron transport material.

Below, each element of the light-emitting device according to this embodiment will be described in detail.

### Electron Transport Layer

In this embodiment, from the standpoint of light extraction efficiency of the light-emitting device, the refractive index of light at a wavelength of 550 nm of the particles contained in the electron transport layer is at least 0.15 smaller, preferably at least 0.18 smaller, and more preferably at least 0.20 smaller than the refractive index of light at a wavelength of 550 nm of the non-particle electron transport material.

The particles contained in the electron transport layer have a Z-average size of 300 nm or less, preferably 250 nm or less, and more preferably 200 nm or less, as determined by dynamic light scattering. A particle size within these numerical ranges leads to reduced electric leakage from the light-emitting device.

The particles contained in the electron transport layer have a Z-average size of 110 nm or more, preferably 130 nm or more, more preferably 150 nm or more, still more preferably 170 nm or more, and particularly preferably 190 nm or more, as determined by dynamic light scattering. A particle size within these numerical ranges leads to excellent light extraction efficiency.

In the present invention, the Z-average size can be calculated, for example, using dynamic light scattering. Specifically, for example, a solution in which particles are dispersed is placed in a measurement cell and exposed to light irradiation, and the Z-average size is calculated from the viscosity of the solution and the temperature based on the principle of Brownian motion.

The refractive index of light at a wavelength of 550 nm of the material that constitutes the particles contained in the electron transport layer is preferably 1.7 or less, more preferably 1.6 or less, still more preferably 1.5 or less, and particularly preferably 1.4 or less from the standpoint of light extraction efficiency.

In the present invention, the refractive index can be calculated using ellipsometry. Specifically, the refractive index of the non-particle electron transport material can be determined by forming a thin film on a substrate and calculating the refractive index using ellipsometry.

The particles contained in the electron transport layer may be formed from an organic compound or an inorganic compound. In the present invention, the particles contained in the electron transport layer are characterized in that refractive index n1 of light at a wavelength of 550 nm of the material that constitutes the particles has the relation expressed by the formula described above with refractive index n2 of light at a wavelength of 550 nm of the non-particle electron transport material. In the present invention, the refractive index of the material that constitutes the particles can be determined by forming a thin film on a substrate for measurement and calculating the refractive index using ellipsometry.

Examples of particles contained in the electron transport layer include particles formed from an organic compound or an inorganic compound. Examples of particles formed of an organic compound include particles formed from a fluorine-atom-containing organic compound, such as fluorine-atom-containing polymethyl methacrylate beads, fluorine-atom-containing acrylic-styrene copolymer beads, fluorine-atom-containing polycarbonate beads, and polyvinyl fluoride beads; and particles formed from an organic compound, such as acrylic, polypropylene, ethylene propylene, urethane, polymethylmethacrylate, urethane rubber, vinyl rubber, nitrile rubber, polyethylene, and nylon. Examples of particles formed of an inorganic compound include particles formed from magnesium fluoride, lithium fluoride, calcium fluoride, and silica. The particles contained in the electron transport layer are preferably particles formed from a fluorine-atom-containing organic compound and particles formed from silica, and more preferably particles formed from silica. These particles may be solid particles or particles with a void at the center (e.g., hollow particles). These particles may be surface-modified to improve dispersibility. The refractive index of hollow particles for use as those contained in the electron transport layer can be determined by uniformly laying the particles on a substrate to form a layer of a predetermined thickness, and calculating the refractive index using ellipsometry. The particles for use may be a single type or a combination of two or more types.

The electron transport material is classified into polymer compounds and low-molecular-weight compounds. In this embodiment, the electron transport material may be a polymer compound or a low-molecular-weight compound, and is preferably an aromatic compound. The electron transport material may also contain crosslinkable groups, or may be crosslinked by crosslinkable groups.

In the present invention, the non-particle electron transport material refers to a material whose Z-average size is less than 110 nm as determined by placing a solution of the electron transport material in a measurement cell, irradiating the cell with light, and calculating the Z-average size based on the principle of Brownian motion.

Examples of electron transport materials formed from a polymer compound include polyphenylene, polyfluorene, and derivatives thereof. The electron transport material is preferably a polymer compound having a constitutional unit represented by formula (ET-1).

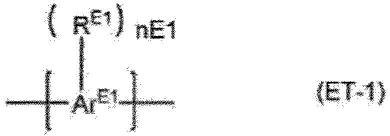

nE1 represents an integer of 1 or more; from the standpoint of excellent solubility of the electron transport material, nE1 preferably represents an integer of 1 to 4, more preferably 1 to 3, and still more preferably 1 or 2. When the polymer compound has a plurality of structural units represented by formula (ET-1), the structural units may be identical or different. For example, the polymer compound may have a repeated structure that includes a constitutional unit of formula (ET-1) in which Ar^{E1} is an optionally substituted group derived from an aromatic hydrocarbon represented by formula 1, described later, and a constitutional unit of formula (ET-1) in which Ar^{E1} is an optionally substituted group derived from an aromatic hydrocarbon represented by formula 4, described later.

Ar^{E1} represents an optionally substituted aromatic hydrocarbon group or an optionally substituted heterocyclic group.

The aromatic hydrocarbon group represented by Ar^{E1} refers to a group obtained by removing nE1 hydrogen atoms directly bonded to carbon atoms that constitute the ring of the arylene group described above. The heterocyclic group represented by Ar^{E1} refers to a group obtained by removing nE1 hydrogen atoms directly bonded to carbon atoms that constitute the ring of the divalent heterocyclic group described above.

The aromatic hydrocarbon group represented by Ar^{E1} is preferably a group obtained by removing hydrogen atoms (the number is 2+nE1) directly bonded to carbon atoms that constitute the ring of the aromatic hydrocarbon represented by any of formulas 1 to 11, more preferably a group obtained by removing hydrogen atoms (the number is 2+nE1) directly bonded to carbon atoms that constitute the ring of the aromatic hydrocarbon represented by any of formula 1, formula 2, formula 4, formula 5, or formula 7, and still more preferably a group obtained by removing hydrogen atoms (the number is 2+nE1) directly bonded to carbon atoms that constitute the ring of the aromatic hydrocarbon represented by formula 1 or 4.

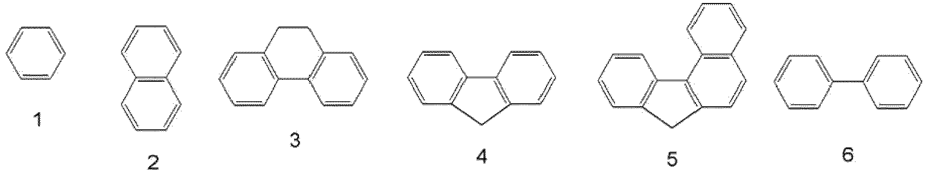

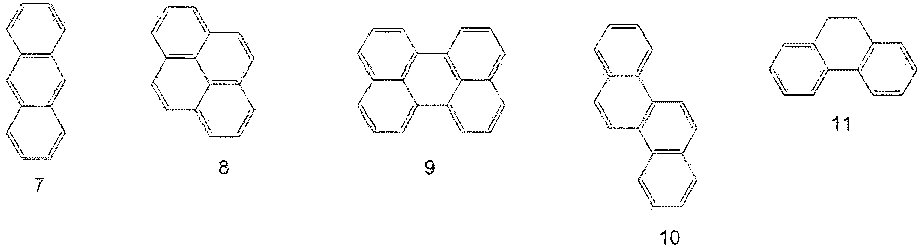

When Ar^{E1} is an aromatic hydrocarbon group, the aromatic hydrocarbon group may further have a substituent in addition to R^{E1}. The substituent may be any substituent, and is, for example, an alkyl group.

Examples of the heterocyclic group represented by Ar^{E1} include a group obtained by removing hydrogen atoms (the number is 2 + nE1) directly bonded to carbon atoms or one or more heteroatoms that constitute the ring of a heterocyclic group, such as pyridine, pyrimidine, triazine, pyrazine, pyridazine, quinoline, quinoxaline, carbazole, dibenzofuran, dibenzothiophene, dibenzosilole, 4a,10a-dihydrophenoxazine, 4a, 10a-dihydrophenothiazine, 4a,9,9a,10-tetrahydroacridine, 4a,5,6a,7,12,12a,14,14a-octahydroquinolino[2,3-b]acridine, pyrrole, furan, thiophene, imidazole, 1,2,4-triazole, oxazole, 1,3,4-oxadiazole, thiazole, and 1,3,4-diazole.

When Ar^{E1} is a heterocyclic group, the heterocyclic group may further have a substituent in addition to R^{E1}. The substituent may be any substituent, and is, for example, an alkyl group.

R^{E1} represents an optionally substituted alkyl group, an optionally substituted cycloalkyl group, an optionally substituted aryl group, an optionally substituted alkoxy group, an optionally substituted cycloalkoxy group, an optionally substituted aryloxy group, or an optionally substituted monovalent group containing one or more heteroatoms. From the standpoint of excellent solubility of the electron transport material in a polar solvent and the ease of stacking a layer on the light-emitting layer, R^{E1} is preferably an optionally substituted monovalent group containing one or more heteroatoms, and more preferably a group represented by -R^{E2} (-X¹)ₘ₁ (wherein R^{E2}, X¹, and m1 are as defined later). When a plurality of R^{E1}s are present, the plurality of R^{E1}s may be identical or different.

Examples of the group having a valence of (m1 + 1) represented by R^{E2} include a single bond, a hydrocarbyl group, and a remaining atomic group obtained by removing m1 hydrogen atom(s) from a monovalent heterocyclic group. The atomic group may optionally be substituted. The group having a valence of (m1 + 1) represented by R^{E2} is, for example, a group represented by -O-(R'O)ₘ- wherein R' represents an optionally substituted hydrocarbylene group (e.g., an optionally substituted alkylene group) when m1 is 1.

The group having a valence of (m1 + 1) represented by R^{E2} is preferably a remaining atomic group obtained by removing m1 hydrogen atom(s) from an optionally substituted alkyl group, a remaining atomic group obtained by removing m1 hydrogen atom(s) from an optionally substituted aryl group, a remaining atomic group obtained by removing m1 hydrogen atom(s) from a monovalent heterocyclic group, a remaining atomic group obtained by removing m1 hydrogen atom(s) from an alkyl group substituted with a monovalent heterocyclic group, or a remaining atomic group obtained by removing m1 hydrogen atom(s) from an aryl group substituted with a monovalent heterocyclic group; and more preferably a remaining atomic group obtained by removing m1 hydrogen atom(s) from an optionally substituted aryl group.

Preferable examples of X¹ include a group represented by formula: -SM, a group represented by formula: -OM, a group represented by formula: -CO₂M, a group represented by formula: - NM₂, a group represented by formula: -NRM, a group represented by formula: -PO₃M, a group represented by formula: -OP(=O) (OM)₂, a group represented by formula: -P(=O) (OM)₂, a group represented by formula: -C(=O)NM₂, a group represented by formula: -C(=O)NRM, a group represented by formula: -SO₃M, a group represented by formula: -SO₂M, a group represented by formula: -NR₃M', a carboxyl group, a sulfo group, a hydroxyl group, a mercapto group, an amino group, a substituted amino group, a cyano group, a pyrrolidonyl group, a phosphate group, a phosphonate group, a substituted phosphonate group, and a monovalent heterocyclic group.

R is as defined above.

M represents a metallic cation or an optionally substituted ammonium cation.

M' represents an anion.

The metallic cation represented by M is preferably a monovalent, divalent, or trivalent ion, for example, a metallic ion such as Li, Na, K, Cs, Be, Mg, Ca, Ba, Ag, Al, Bi, Cu, Fe, Ga, Mn, Pb, Sn, Ti, V, W, Y, Yb, Zn, and Zr; and is preferably an Li, Na, K or Cs ion.

Examples of the substituent that may be contained in the ammonium cation represented by M include C₁₋₁₀ alkyl, such as a methyl group, an ethyl group, a propyl group, an isopropyl group, a butyl group, isobutyl group, a sec-butyl group, and a tert-butyl group.

Examples of the anion represented by M' include F⁻, Cl⁻, Br⁻, I⁻, OH⁻, ClO⁻, ClO₂⁻, ClO₃⁻, ClO₄⁻, SCN⁻, CN⁻, NO₃⁻, SO₄²⁻, HSO₄⁻, PO₄³⁻, HPO₄²⁻, H₂PO₄⁻, BF₄⁻, PF₆⁻, CH₃SO₃⁻, CF₃SO₃⁻, [(CF₃SO₂)₂N]⁻, a tetrakis(imidazolyl)borate anion, an 8-quinolinolato anion, a 2-methyl-8-quinolinolato anion, and a 2-phenyl-8-quinolinolato anion.

Preferable examples of X¹ also include groups represented by formulas (I) to (IX).

-O-(R'O)m-R" (I)

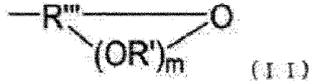

-S-(R'S)q-R" (III)

-C(=O)-(R'-C(=O))_{q}-R" (IV)

-C(=S)-(R'-C(=S))_{q}-R" (V)

-N{(R')_{q}R"}₂ (VI)

-C(=O)O-(R'-C(=O)O)_{q}-R" (VII)

-C(=O)-O-(R'O)_{q}-R" (VIII)

-NHC(=O)-(R'NHC(=O))_{q}-R" (IX)

wherein
R' represents an optionally substituted hydrocarbylene group;
R" represents a hydrogen atom, an optionally substituted hydrocarbyl group, a carboxyl group, a sulfo group, a hydroxyl group, a mercapto group, an amino group, a group represented by - NR^{c}₂, a cyano group, or a group represented by -C(=O)NR^{c}₂;
R''' represents an optionally substituted trivalent hydrocarbon group;
m represents an integer of 1 or more;
q represents an integer of 0 or more;
R^{c} represents an optionally substituted C₁₋₃₀ alkyl group or an optionally substituted C₆₋₅₀ aryl group; and
when a plurality of R's, R"s, and R'''s are each present, they may be identical or different.

m1 represents an integer of 1 or more; from the standpoint of excellent solubility of the electron transport material, m1 is preferably an integer of 1 to 4, more preferably an integer of 1 to 3, and still more preferably 1 or 2.

Examples of the group represented by formula -R^{E2}(-X¹)ₘ₁ include the groups represented by the following formulas. 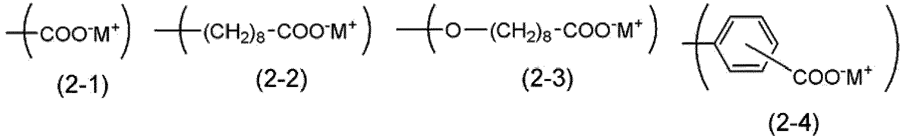 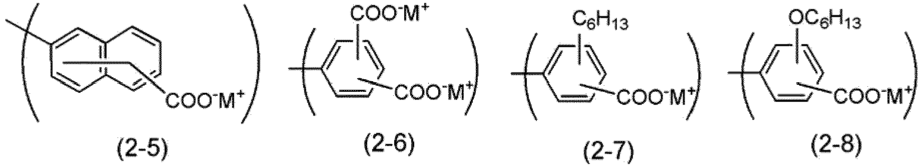 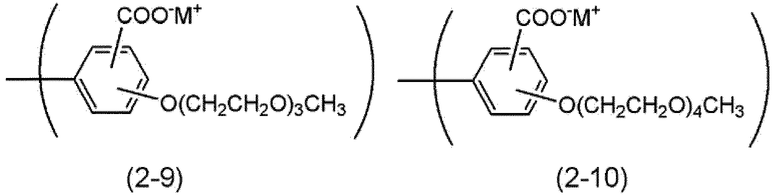 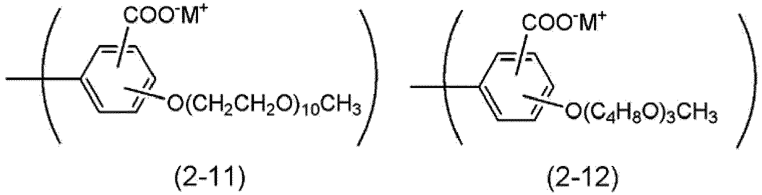 wherein M⁺ represents Li⁺, Na⁺, K⁺, Rb⁺, Cs⁺, or N⁺(CH₃)₄; when a plurality of M⁺ ions are present, the ions may be identical or different. 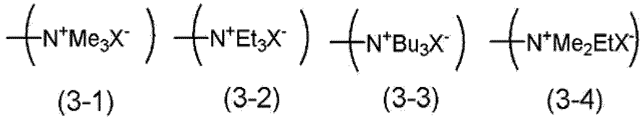 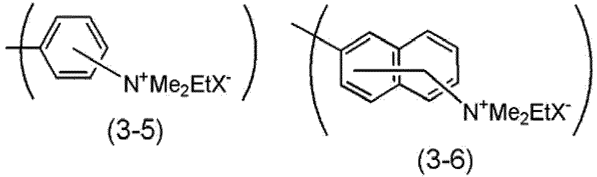 wherein X⁻ represents F⁻, Cl⁻, Br⁻, I⁻, B⁻ (C₆H₅)₄, CH₃COO⁻, or CF₃SO₃⁻.

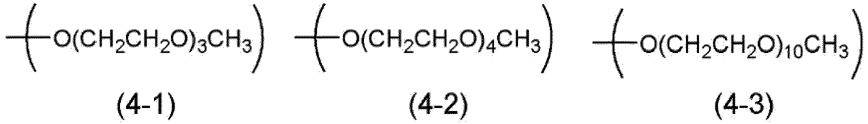

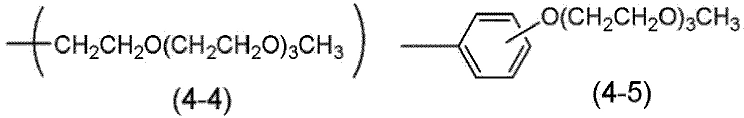

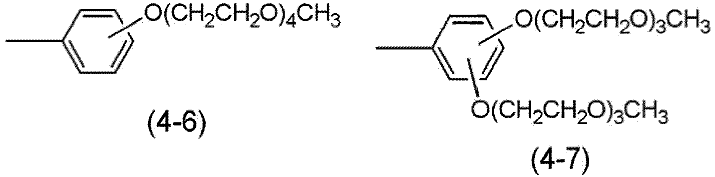

The polymer compound that serves as an electron transport material can be synthesized in accordance with the method disclosed in, for example, JP2009-239279A, JP2012-033845A, JP2012-216821A, JP2012-216822A, or JP2012-216815A.

### Preferable Forms of the Constitutional Unit Represented by Formula (ET-1)

Examples of the constitutional unit represented by formula (ET-1) include constitutional units represented by the following formulas. 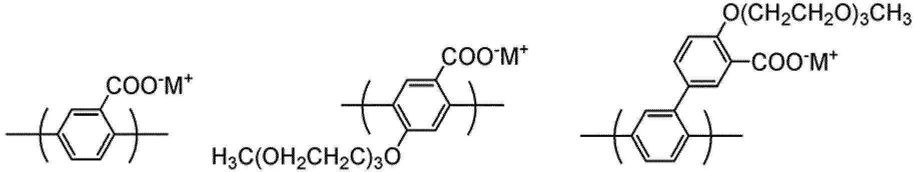 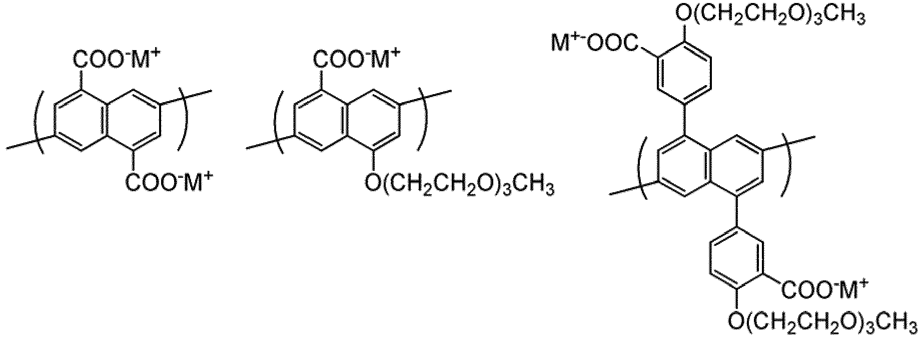 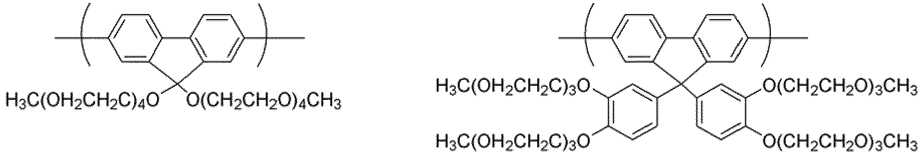 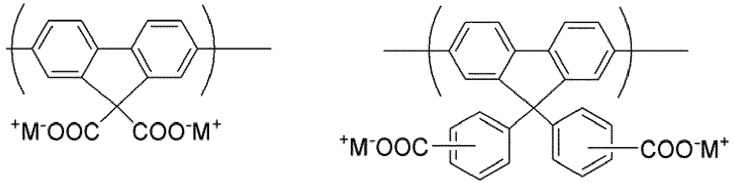 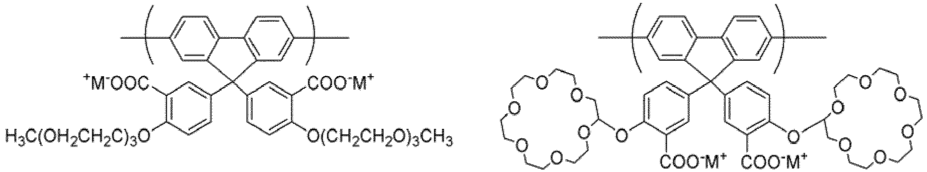 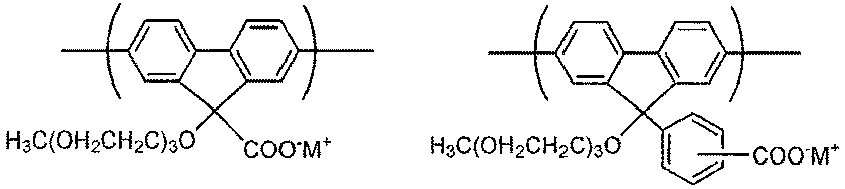 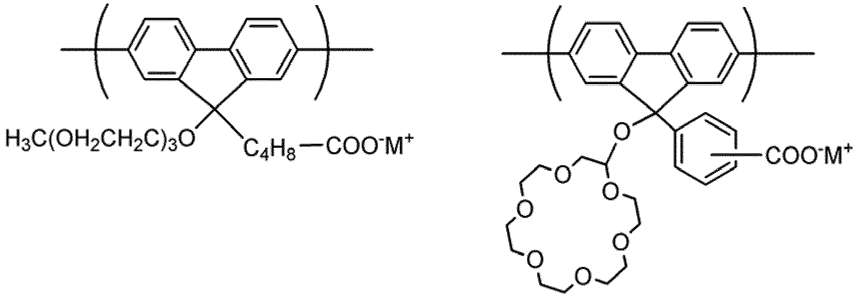 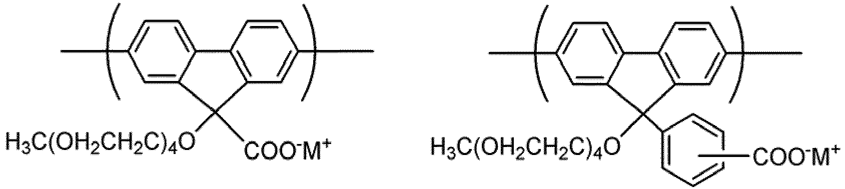 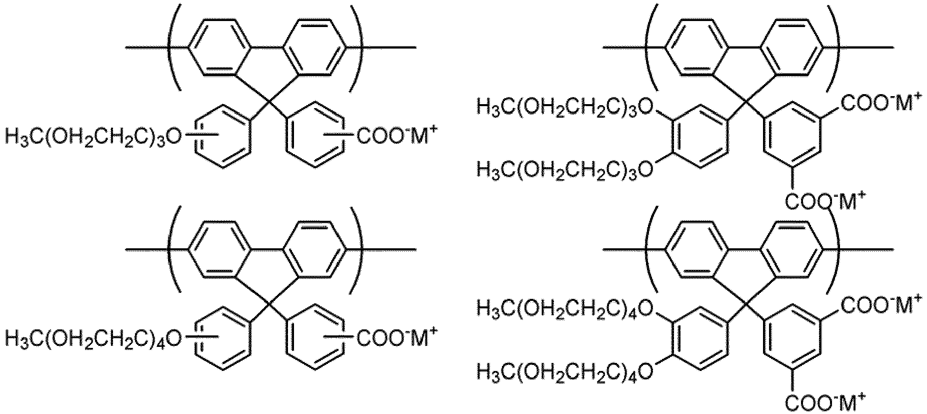 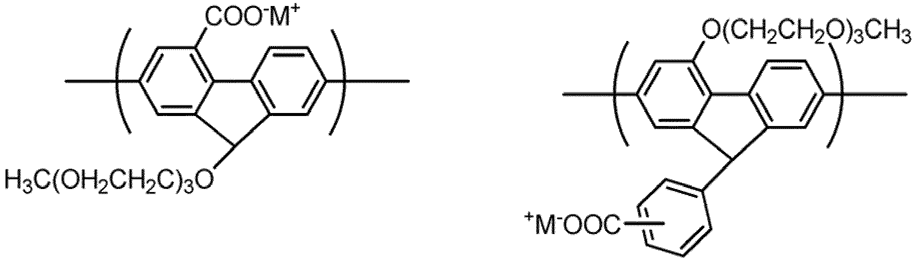 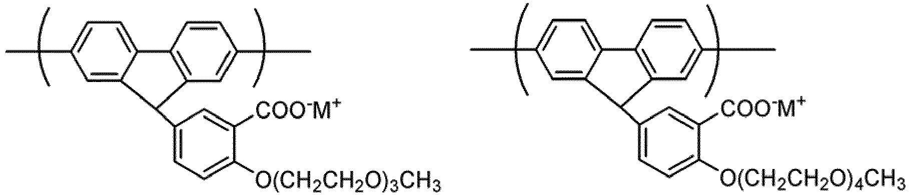 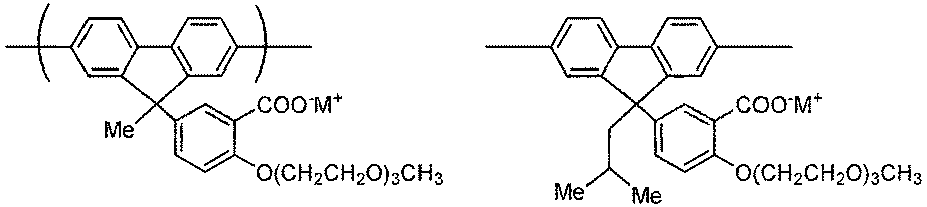 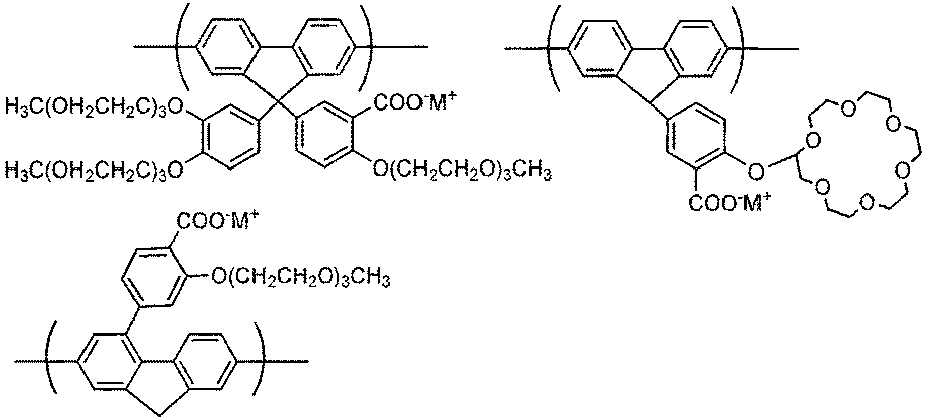 wherein M⁺ is as defined above; when a plurality of M⁺ ions are present, the ions may be identical or different.

Examples of electron transport materials formed from a low-molecular-weight compound include a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, carbazole, azacarbazole, diazacarbazole, benzimidazole, triazine, diphenoquinone, and derivatives thereof. The electron transport material of a low-molecular-weight compound is preferably a low-molecular-weight compound represented by formula (H-1). 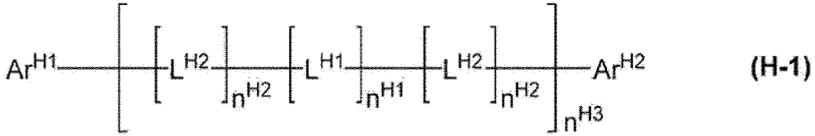 wherein Ar^{H1}, Ar^{H2}, L^{H1}, L^{H2}, n^{H1}, n^{H2}, and n^{H3} are as defined above.

Ar^{H1} and Ar^{H2} are preferably phenyl, fluorenyl, spirobifluorenyl, pyridyl, pyrimidinyl, triazinyl, quinolinyl, isoquinolinyl, thienyl, benzothienyl, dibenzothienyl, furyl, benzofuryl, dibenzofuryl, pyrrolyl, indolyl, azaindolyl, carbazolyl, azacarbazolyl, diazacarbazolyl, phenoxazinyl, or phenothiazinyl; more preferably phenyl, spirobifluorenyl, pyridyl, pyrimidinyl, triazinyl, dibenzothienyl, dibenzofuryl, carbazolyl, or azacarbazolyl; and still more preferably azacarbazolyl. These groups may optionally be substituted.

The substituent that may be contained in Ar^{H1} and Ar^{H2} is preferably a halogen atom, alkyl, cycloalkyl, alkoxy, cycloalkoxy, aryl, or a monovalent heterocyclic group; more preferably alkyl, cycloalkoxy, alkoxy, or cycloalkoxy; and still more preferably alkyl or cycloalkoxy. These groups may further optionally be substituted.

n^{H1} is preferably 1, and n^{H2} is preferably 0.

n^{H3} is typically an integer of 0 or more and 10 or less, preferably an integer of 0 or more and 5 or less, more preferably an integer of 1 or more and 3 or less, and particularly preferably 1.

L^{H1} is preferably an arylene group or a divalent heterocyclic group.

L^{H1} is preferably a group represented by any of formulas (A-1) to (A-3), (A-8) to (A-10), (AA-1) to (AA-6), (AA-10) to (AA-21), and (AA-24) to (AA-34); more preferably a group represented by any of formulas (AA-11) to (AA-15); still more preferably a group represented by formula (AA-14) or (AA-15); and particularly preferably a group represented by formula (AA-14).

The substituent that may be contained in L^{H1} is preferably a halogen atom, alkyl, cycloalkyl, alkoxy, cycloalkoxy, or aryl; and more preferably alkyl. These groups may further optionally be substituted.

L^{H2} is a group represented by -N(-L^{H21}-R^{H21})-. L^{H21} is preferably a single bond or an optionally substituted arylene group, and more preferably a single bond. The arylene group or divalent heterocyclic group represented by L^{H21} include those listed as examples of the arylene group or divalent heterocyclic group represented by L^{H1}. The aryl group and monovalent heterocyclic group represented by R^{H21} include those listed as examples of the aryl group and monovalent heterocyclic group represented by Ar^{H1} or Ar^{H2}. The definition and examples of the substituent that may be contained in R^{H21} are the same as those of the substituent of Ar^{H1} and Ar^{H2}.

The compound represented by formula (H-1) is preferably a compound represented by formula (H-2). 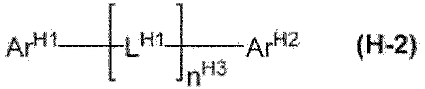 wherein Ar^{H1}, Ar^{H2}, and L^{H1} are as defined above; and n^{H3} represents an integer of 0 or more.

Examples of the compound represented by formula (H-1) include the compounds represented by formulas (H-101) to (H-123). The compound represented by formula (H-1) is preferably the compound represented by any of formulas (H-101) to (H-111), and (H-113) to (H-123); more preferably the compound represented by any of formulas (H-101) to (H-106), (H-111), and (H-113) to (H-123); still more preferably the compound represented by any of formulas (H-101) to (H-106), (H-122), and (H-123); and particularly preferably the compound represented by formula (H-122) or (H-123).

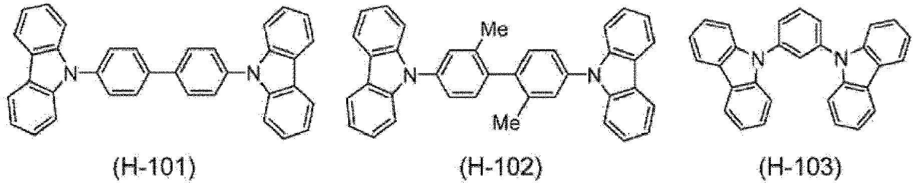

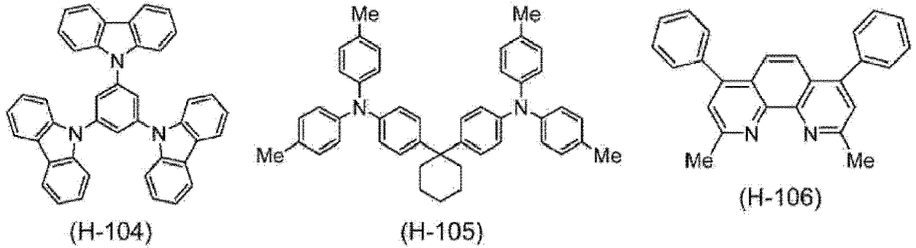

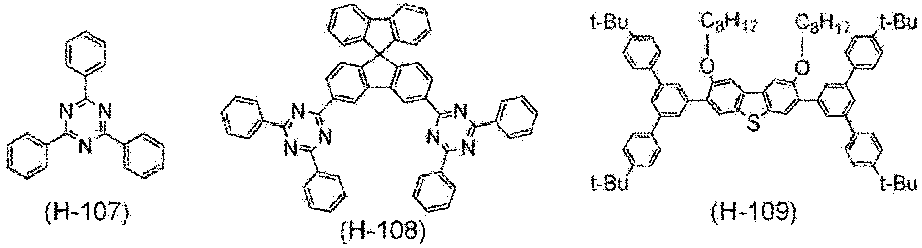

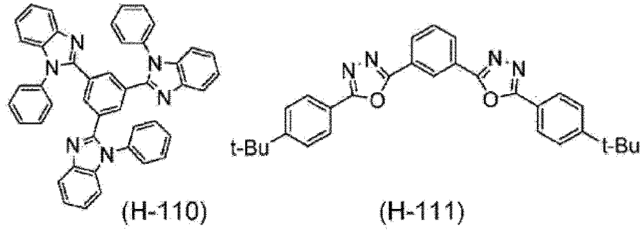

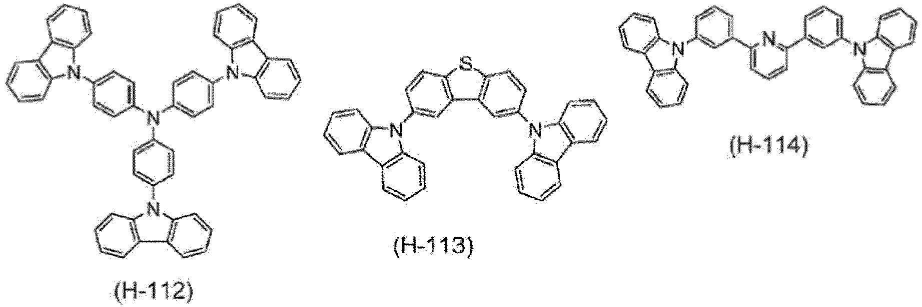

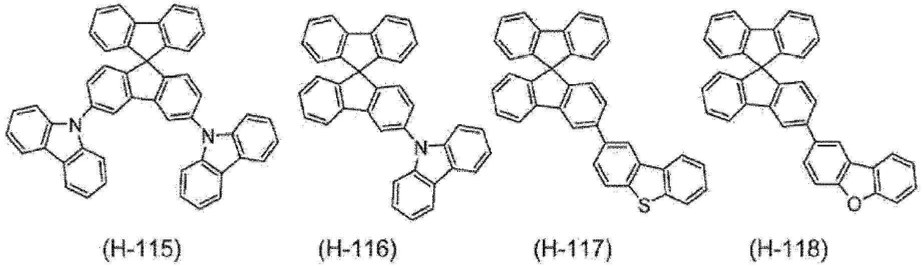

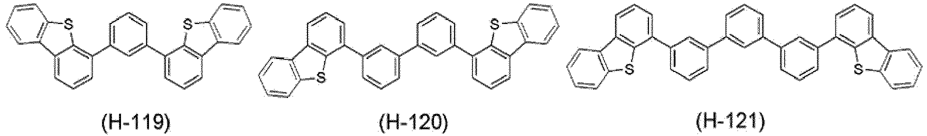

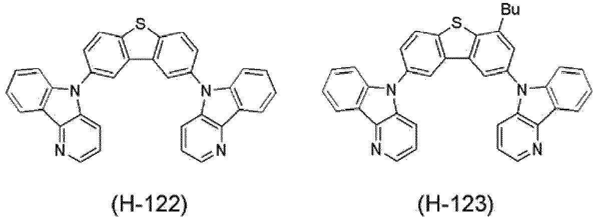

Electron transport materials for use in the light-emitting device according to this embodiment, other than the polymer compound that has the constitutional unit represented by formula (ET-1) and the compound represented by formula (H-1), may be known materials. Examples include triazole, derivatives thereof, oxazole, derivatives thereof, oxadiazole, derivatives thereof, imidazole, derivatives thereof, fluorene, derivatives thereof, benzoquinone, derivatives thereof, naphthoquinone, derivatives thereof, anthraquinone, derivatives thereof, tetracyanoanthraquinodimethane, derivatives thereof, fluorenone, derivatives thereof, diphenyldicyanoethylene, derivatives thereof, diphenoquinone, derivatives thereof, anthraquinodimethane, derivatives thereof, anthrone, derivatives thereof, thiopyran dioxide, derivatives thereof, carbodiimide, derivatives thereof, fluorenylidenemethane, derivatives thereof, distyrylpyrazine, derivatives thereof, aromatic tetracarboxylic anhydrides such as naphthalene and perylene, phthalocyanine, derivatives thereof, metal complexes such as 8-quinolinol and derivatives thereof, metal phthalocyanine, various metal complexes, including metal complexes having benzoxazole or benzothiazole as a ligand, organosilanes, derivatives thereof, metal complexes such as 8-hydroxyquinoline and derivatives thereof, polyquinoline, derivatives thereof, polyquinoxaline, derivatives thereof, polyfluorenes, and derivatives thereof. Of these, triazole, derivatives thereof, oxadiazole, derivatives thereof, benzoquinone, derivatives thereof, anthraquinone, derivatives thereof, and metal complexes of 8-hydroxyquinoline and derivatives thereof, polyquinoline, derivatives thereof, polyquinoxaline, derivatives thereof, polyfluorene, and derivatives thereof are preferable.

The proportion of the particles is preferably 1 to 200 parts by mass relative to 100 parts by mass of the electron transport material in the electron transport layer. From the standpoint of light extraction efficiency, the proportion of the particles is preferably 10 parts by mass or more, more preferably 30 parts by mass or more, and still more preferably 50 parts by mass or more. From the standpoint of excellent conductivity of the electron transport layer, the proportion of the particles is preferably 180 parts by mass or less, more preferably 150 parts by mass or less, and still more preferably 120 parts by mass or less.

The electron transport materials may be used singly or in a combination of two or more.

The number of particles per unit area contained in the electron transport layer is preferably 0.1/µm² or more, more preferably 0.5/µm² or more, and still more preferably 1/µm² or more. The number of particles per unit area contained in the electron transport layer can be determined, for example, by photographing the light-emitting device in the direction perpendicular to the plane of the light-emitting device with an atomic force microscope, measuring the number of particles present in an area of 10 µm × 10 µm in the obtained image, and dividing the number by 100.

The number of particles per unit area (which is sometimes referred to as "particle density" in the present specification) contained in the electron transport layer can be measured, for example, by forming a film of a solution for forming the electron transport layer on a glass substrate, measuring an area of 10 µm × 10 µm of the formed film with an atomic force microscope, and analyzing the obtained image; measuring a visual field (10 µm × 10 µm or larger) with a scanning electron microscope, and analyzing the obtained image; or optically observing a visual field (10 µm × 10 µm or larger) with an optical microscope, microscope, etc., and analyzing the obtained image.

The electron transport layer is preferably adjacent to the cathode (if an electron injection layer is present, then the electron injection layer). The interface between the electron transport layer and the cathode or electron injection layer preferably has a root mean square roughness of 1 nm or more, more preferably 3 nm or more, still more preferably 5 nm or more, particularly preferably 10 nm or more, and still yet more preferably 15 nm or more.

The interface between the electron transport layer and the cathode (if an electron injection layer is present, then the electron injection layer) preferably has a root mean square roughness of 80 nm or less, more preferably 60 nm or less, and particularly preferably 40 nm or less. The root mean square roughness can be determined, for example, by photographing the light-emitting device in the direction perpendicular to the plane of the light-emitting device with an atomic force microscope, and analyzing a measurement area of 10 µm × 10 µm in the obtained image.

From the standpoint of light extraction efficiency, the maximum difference in height of the interface between the electron transport layer and the cathode (if an electron injection layer is present, then the electron injection layer) is preferably 50 nm or more, more preferably 80 nm or more, and still more preferably 100 nm or more.

The maximum difference in height of the interface between the electron transport layer and the cathode (if an electron injection layer is present, then the electron injection layer) is preferably 300 nm or less, more preferably 250 nm or less, and still more preferably 200 nm or less. It is preferable to have a maximum difference in height within the ranges described above because doing so leads to reduced leakage of current from the light-emitting device. The maximum difference in height of the interface between the electron transport layer and the cathode (if an electron injection layer is present, then the electron injection layer) can be determined, for example, by photographing the light-emitting device in the direction perpendicular to the plane of the light-emitting device with an atomic force microscope, and analyzing the obtained image.

Due to the presence of the difference in height of the interface between the electron transport layer and the cathode, the thickness of the thinnest portion of the electron transport layer is typically 1 nm to 1µm, preferably 2 nm to 500 nm, and more preferably 5 nm to 100 nm. The thickness of the thickest portion of the electron transport layer is typically 110 nm to 1 µm, preferably 120 nm to 500 nm, and more preferably 130 nm to 350 nm.

### Light-emitting Layer

In this embodiment, the light-emitting layer may be a layer that contains a luminescent material. The luminescent material is classified into low-molecular-weight compounds and polymer compounds. The luminescent material may be a polymer compound or a low-molecular-weight compound. The luminescent material may contain crosslinkable groups, or may be crosslinked by crosslinkable groups.

Examples of low-molecular-weight compounds for use as a luminescent material include naphthalene, derivatives thereof, anthracene, derivatives thereof, perylene, derivatives thereof, and triplet light-emitting complexes (i.e., phosphorescent materials) having iridium, platinum, or europium as the central metal.

Examples of polymer compounds for use as the luminescent material include polymer compounds containing a phenylene group, a naphthalenediyl group, a fluorenediyl group, a phenanthrenediyl group, a dihydrophenanthrenediyl group, a carbazolediyl group, a phenoxazinediyl group, a phenothiazinediyl group, an anthracenediyl group, or a pyrenediyl group.

In this embodiment, the luminescent material preferably contains a triplet light-emitting complex.

The triplet light-emitting complex is preferably an iridium complex, such as metal complexes represented by formulas Ir-1 to Ir-5. 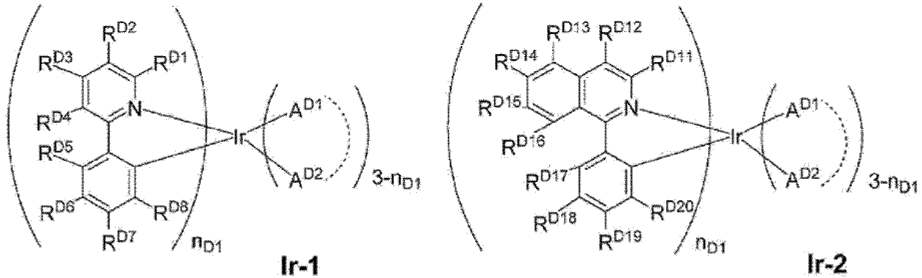 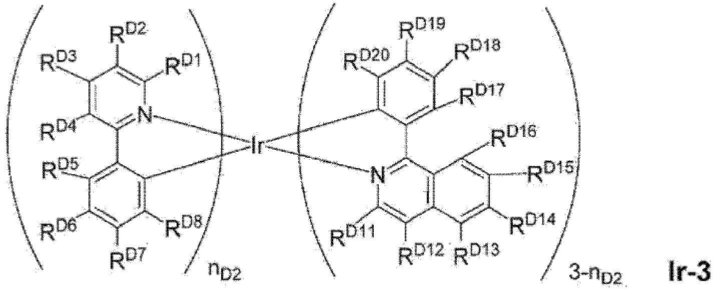 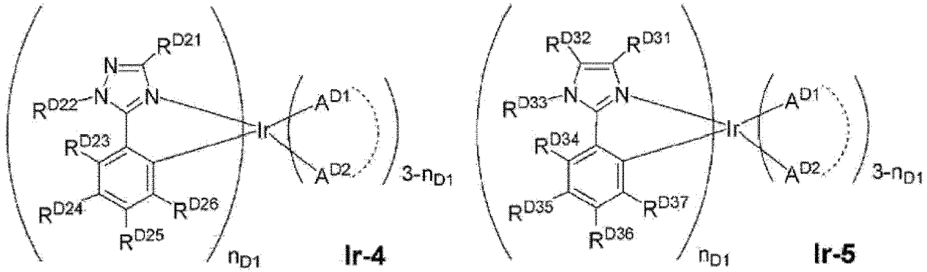 wherein
R^{D1} to R^{D8}, R^{D11} to R^{D20}, R^{D21} to R^{D26}, and R^{D31} to R^{D37} each independently represent a hydrogen atom, an alkyl group, a cycloalkyl group, an alkoxy group, a cycloalkoxy group, an aryl group, an aryloxy group, a monovalent heterocyclic group, or a halogen atom; some or all of the hydrogen atoms in these groups (e.g., one to all of the hydrogen atoms that can be replaced) may optionally be replaced with a substituent; when a plurality of R^{D1} to R^{D8}, R^{D11} to R^{D20}, R^{D21} to R^{D26}, and R^{D31} to R^{D37} are present, these groups may be identical or different;
-A^{D1}---A^{D2}- represents an anionic bidentate ligand, and A^{D1} and A^{D2} each independently represent a carbon atom, oxygen atom, or nitrogen atom that binds to the iridium atom; these atoms may be part of the ring; when a plurality of -A^{D1}---A^{D2}- are present, the plurality of -A^{D1}---A^{D2}- may be identical or different; and
n^{D} represents 1, 2, or 3, and n^{D2} represents 1 or 2.

The anionic bidentate ligand represented by -A^{D1}---A^{D2}-is not particularly limited; examples include ligands represented by the following formulas. 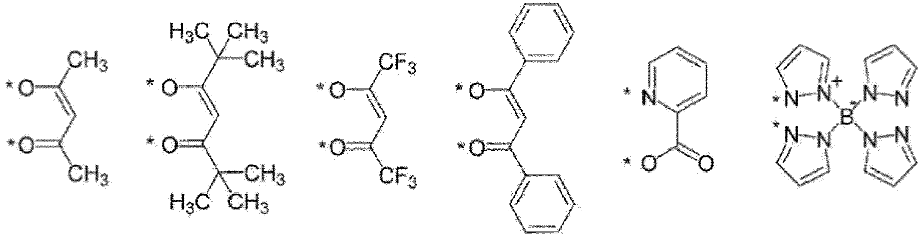 wherein the symbol "*" represents the site that binds to Ir.

Examples of the triplet light-emitting complex include metal complexes illustrated below.

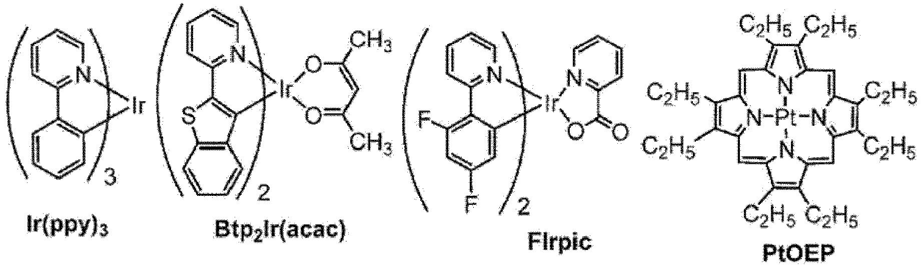

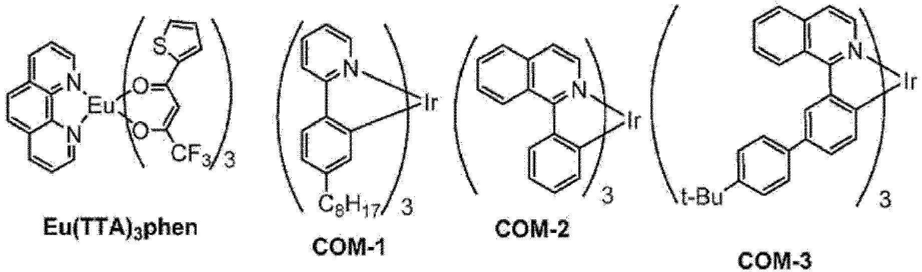

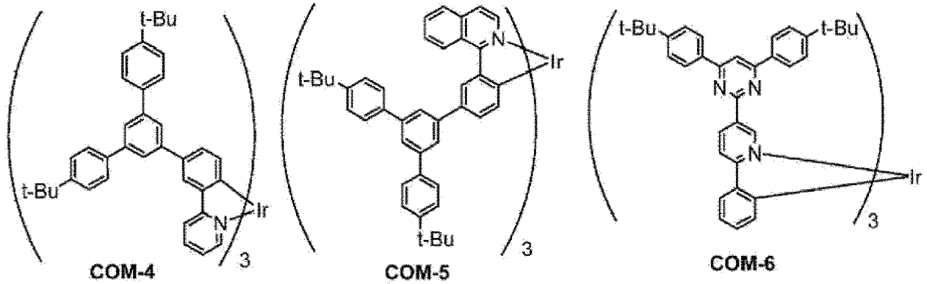

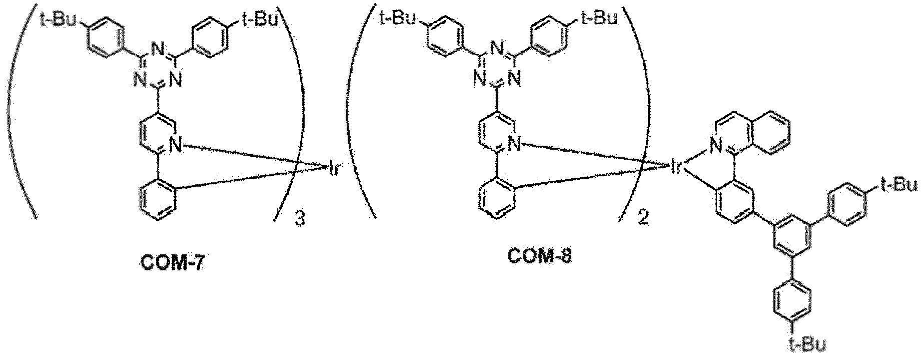

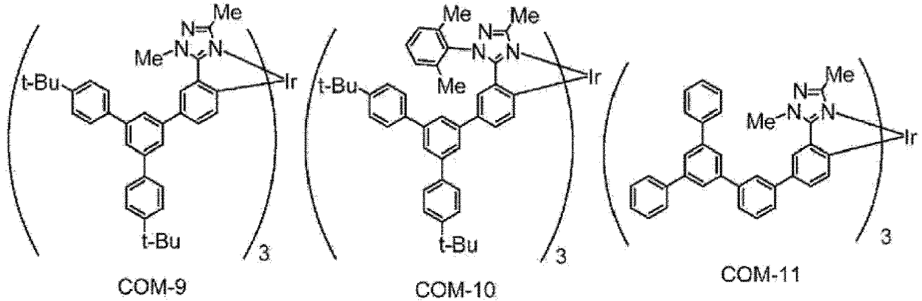

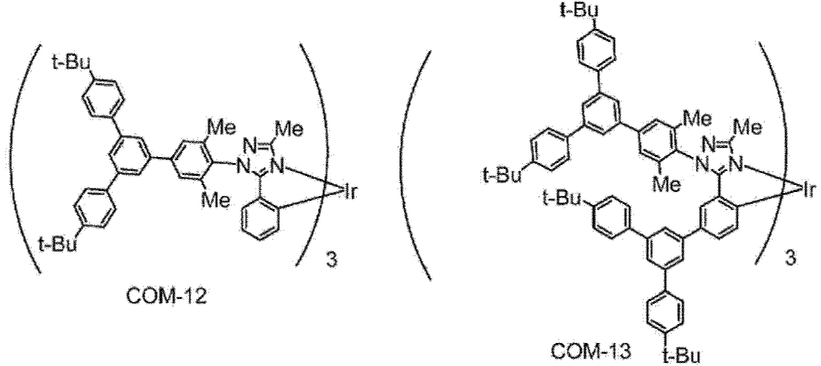

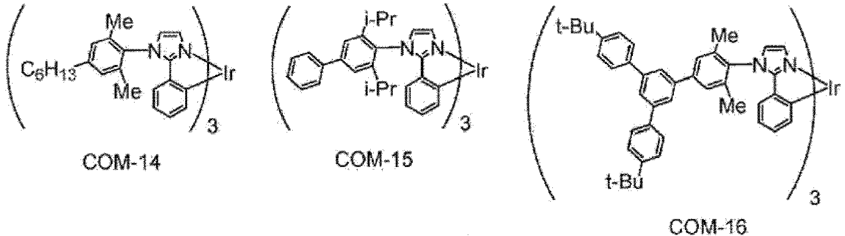

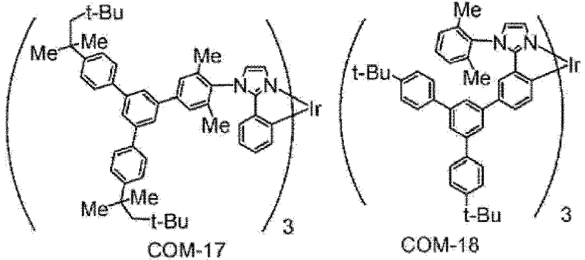

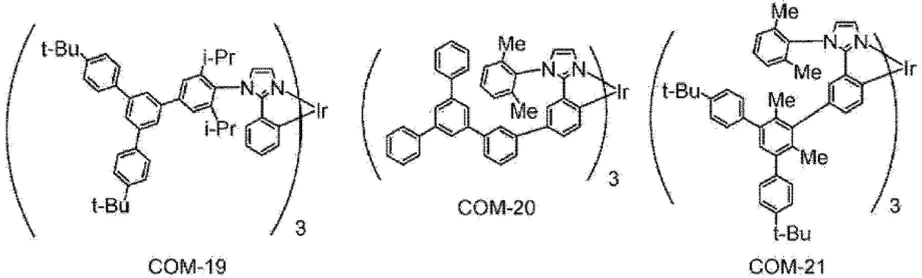

In the present invention, the luminescent material for use may be one type or a combination of two or more types of luminescent materials.

In this embodiment, the light-emitting layer preferably contains a host material together with the luminescent material. The host material is classified into low-molecular-weight compounds and polymer compounds. The host material may be a polymer compound or a low-molecular-weight compound.

The low-molecular-weight compound for use as a host material includes compounds with a carbazole skeleton, compounds with a triaryl amine skeleton, compounds with a phenanthroline skeleton, compounds with a triaryltriazine skeleton, compounds with an azole skeleton, compounds with a benzothiophene skeleton, compounds with a benzofuran skeleton, compounds with a fluorene skeleton, and compounds with a spirofluorene skeleton. The compounds represented by the following formulas are some examples:

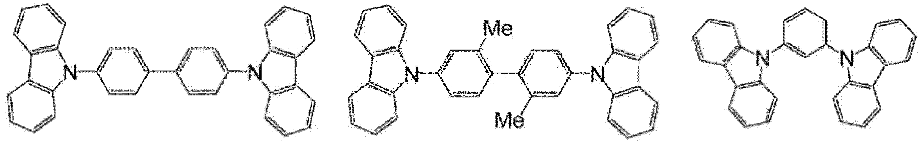

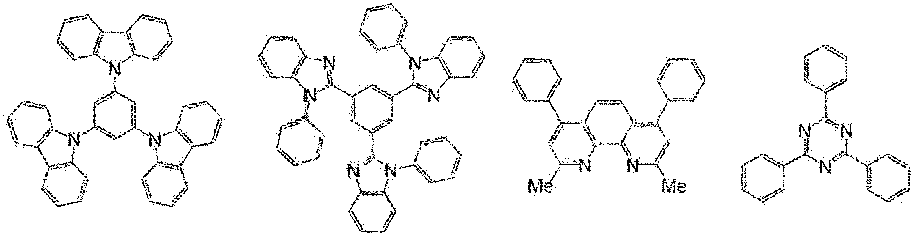

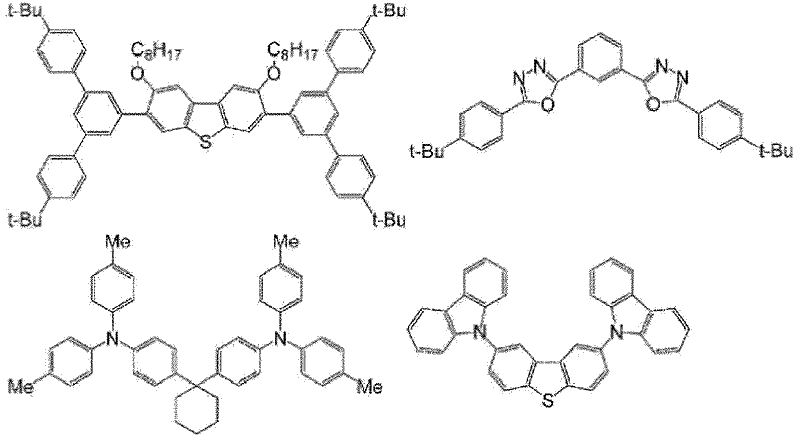

The polymer compound for use as a host material (which may be referred to as "polymer host" below) can be selected from a wide range of host materials for use in light-emitting layers in the technical field to which the present invention pertains. In the present invention, preferable examples include the polymer compound having the constitutional unit represented by formula (Y) .

-[-Ar^{Y1}-]- (Y)

wherein Ar^{Y1} represents an arylene group, a divalent heterocyclic group, or a divalent group formed by at least one arylene group directly bonded to at least one divalent heterocyclic group; and some or all of the hydrogen atoms in these groups (e.g., one to all of the hydrogen atoms that can be replaced) may optionally be replaced with a substituent.

The polymer host may be a block copolymer, a random copolymer, an alternating copolymer, or a graft copolymer, or another form. The polymer host is preferably a copolymer formed by copolymerizing a plurality of starting material monomers.

The polymer host can be produced, for example, by a known polymerization method described in Chemical Reviews (Chem. Rev.), Vol. 109, pp. 897-1091 (2009). Examples of the method for producing the polymer host include a method in which polymerization is performed by a coupling reaction using a transition metal catalyst, such as a Suzuki reaction, Yamamoto reaction, Buchwald reaction, Stille reaction, Negishi reaction, and Kumada reaction.

In the polymerization method, the method for adding monomers includes a method in which all of the monomers are added to a reaction system at one time; a method in which some of the monomers are added and a reaction is allowed to proceed, after which the remaining monomers are added at one time, in a continuous manner, or in several portions; and a method in which monomers are added in a continuous manner or in several portions.

The transition metal catalyst includes a palladium catalyst and a nickel catalyst.

Post-treatment of the polymerization reaction may be performed by a known method. For example, the following methods may be used singly or in combination: a method in which watersoluble impurities are removed by liquid separation, and a method in which a reaction mixture after polymerization reaction is added to a lower alcohol such as methanol, and the precipitates are filtered, followed by drying the precipitates. A polymer host with low purity can be purified by a typical method, such as crystallization, reprecipitation, continuous extraction using a Soxhlet extractor, or column chromatography. In the present invention, the host material may be used singly or in a combination of two or more.

The light-emitting layer has a thickness of typically 5 nm to 1 µm, preferably 10 nm to 500 nm, and more preferably 30 nm to 200 nm.

### Electrode

The light-emitting device according to this embodiment includes an anode and a cathode.

Examples of the material for the anode include conductive metal oxides and translucent metals; preferably, indium oxide, zinc oxide, tin oxide (e.g., NESA); conductive compounds, such as indium tin oxide (ITO), and indium zinc oxide; composites of silver, palladium, and copper (APC); and gold, platinum, silver, and copper.

The cathode of the light-emitting device according to the present invention may have a single-layer structure composed of a single material or of a plurality of materials, or a multilayer structure composed a plurality of layers. When the cathode has a single-layer structure, examples of the material of the cathode include metals with low resistivity (e.g., gold, silver, copper, aluminum, chromium, tin, lead, nickel, and titanium), alloys containing such metals with low resistivity, conductive metal oxides (e.g., tin oxide, zinc oxide, indium oxide, ITO, indium zinc oxide (IZO), and molybdenum oxide), and mixtures of these conductive metal oxides and metals, with aluminum and alloys containing aluminum being preferable. When the cathode has a multilayer structure, the layer closest to the light-emitting layer, of the plurality of cathode layers that constitute the cathode, is referred to as the "first cathode layer" in this specification. The layer subsequent to the first cathode layer is referred to as the "second cathode layer," the layer subsequent to the second cathode layer is referred to as the "third cathode layer," and so forth.

The light-emitting device according to the present invention may include an electron injection layer between the cathode and the electron transport layer. The material of the electron injection layer, is, for example, at least one material selected from the group consisting of alkali metals, alkaline earth metals, alloys containing one or more of these metals, oxides of these metals, halides of these metals, carbonates of these metals, composite oxides of these metals, and mixtures thereof. Examples of alkali metals, oxides of these metals, halides of these metals, carbonates of these metals, and composite oxides of these metals include lithium, sodium, potassium, rubidium, cesium, lithium oxide, sodium oxide, potassium oxide, rubidium oxide, cesium oxide, lithium fluoride, sodium fluoride, potassium fluoride, rubidium fluoride, cesium fluoride, lithium carbonate, sodium carbonate, potassium carbonate, rubidium carbonate, cesium carbonate, potassium molybdate, potassium titanate, potassium tungstate, and cesium molybdate. Examples of alkaline earth metals, oxides of these metals, halides of these metals, carbonates of these metals, and composite oxides of these metals include magnesium, calcium, strontium, barium, magnesium oxide, calcium oxide, strontium oxide, barium oxide, magnesium fluoride, calcium fluoride, strontium fluoride, barium fluoride, magnesium carbonate, calcium carbonate, strontium carbonate, barium carbonate, barium molybdate, and barium tungstate. Examples of alloys containing one or more alkali metals or alkaline earth metals include Li-Al alloys, Mg-Ag alloys, Al-Ba alloys, Mg-Ba alloys, Ba-Ag alloys, and Ca-Bi-Pb-Sn alloys. Additionally, a composition of a material listed as an example of the material of the cathode layer and a material listed as the material that constitutes the electron injection layer can also be used in the electron injection layer. From the standpoint of electron donation capability, the material of the electron injection layer preferably has a work function of 3.5 eV or less. An oxide, fluoride, carbonate, composite oxide, or the like of a metal with a work function of 3.5 eV or less can be suitably used as a material of the electron injection layer. These materials of the electron injection layer may be used singly or in a combination of two or more. Examples of the material of the layers following the first cathode layer are those listed as materials of the electron injection layer.

When the cathode has a multilayer structure, the material of each cathode layer for suitable use is, for example, a metal or metal oxide with low resistivity and high corrosion resistance to water. More specifically, the material of each cathode layer includes metals with low resistivity (e.g., gold, silver, copper, aluminum, chromium, tin, lead, nickel, and titanium), alloys containing these metals, metal nanoparticles containing these metals, metal nanowires containing these metals, conductive metal oxides (e.g., tin oxide, zinc oxide, indium oxide, ITO, IZO, and molybdenum oxide), mixtures of these conductive metal oxides and metals, nanoparticles of conductive metal oxides, and conductive carbons (e.g., graphene, fullerene, and carbon nanotubes). The material for use in each of the layers that constitute the cathode layers may be a single material or a combination of two or more materials selected from the materials described above.

In the present invention, the light-emitting device preferably includes an electron injection layer. For example, a two-layer structure of the electron injection layer and the first cathode layer, or a three-layer structure of the electron injection layer, the first cathode layer, and the second cathode layer is preferable. Examples of the light-emitting device according to the present invention that includes an electron injection layer include a two-layer structure of the electron injection layer and the first cathode layer, such as Mg/Al, Ca/Al, Ba/Al, NaF/Al, KF/Al, RbF/Al, CsF/Al, Na₂CO₃/Al, K₂CO₃/Al, and Cs₂CO₃/Al; and a three-layer structure of the electron injection layer, the first cathode layer, and the second cathode layer, such as LiF/Ca/Al, NaF/Ca/Al, NaF/Mg/Ag, KF/Ca/Al, RbF/Ca/Al, CsF/Ca/Al, Ba/Al/Ag, KF/Al/Ag, KF/Ca/Ag, and K₂CO₃/Ca/Ag. The slash indicates that the layers are adjacent to each other. The material of the first cathode layer preferably has reduction action on the material of the electron injection layer. Whether reduction action is present between materials and the degree of reduction action can be estimated from, for example, the bond dissociation energy (ΔrH°) between compounds. Specifically, when the bond dissociation energy in the reduction of the material that constitutes the electron injection layer by the material that constitutes the first cathode layer is positive in this combination, the material of the first cathode has reduction action on the material of the electron injection layer. For the bond dissociation energy, for example, *"*Denki Kagaku Binran, 5th Edition" (Maruzen, published in 2000) and Thermodynamic Database MALT (Kagaku Gijutsu-Sha, published in 1992) can be referred to.

The anode and cathode may each have a laminate structure of two or more layers, or a mesh-patterned structure.

The method for producing an electrode for use may be a known method. Examples include vacuum deposition, sputtering, ion plating, and a method for forming a film from a solution (a mixture solution containing a polymer binder may be used). When forming a light-emitting device by roll-to-roll processing, it is preferable to use a method for forming a film from a solution.

The light-emitting device according to this embodiment may be formed on a substrate. The substrate may be any substrate as long as an electrode (an anode or a cathode) can be formed on an entire surface of the substrate, and the substrate does not chemically change during the formation of organic layers (a light-emitting layer and an electron transport layer). For example, the substrate may be formed of a material such as glass, plastic, or silicon. The substrate may be transparent, translucent, or opaque. When the substrate is opaque, the electrode furthest from the substrate is preferably transparent or translucent. When the light-emitting device is produced by roll-to-roll processing, a substrate formed of a plastic material is preferable from the standpoint of excellent flexibility. Examples of plastic materials include polyethylene naphthalate (PEN), polyethersulfone (PES), polyethylene terephthalate (PET), and polycarbonate (PC); from the standpoint of excellent heat resistance, coefficient of thermal expansion, and water absorption, a substrate formed of PEN is preferable.

The light-emitting device according to this embodiment may further include a layer other than the layers described above. For example, the light-emitting device may further include a hole injection layer, hole transport layer, and other layers.

### Hole Injection Layer

The "hole injection layer" refers to a layer that is adjacent to the anode with a function of receiving holes from the anode, and that further optionally has a function of transporting holes, a function of supplying holes to the light-emitting layer, or a function of blocking electrons injected from the cathode. The "hole transport layer" refers to a layer that has a function mainly of transporting holes, and that further optionally has a function of receiving holes from the anode, a function of supplying holes to the light-emitting layer, or a function of blocking electrons injected from the cathode.

The material for forming the hole injection layer for suitable use in the light-emitting device according to this embodiment includes the following: carbazole, derivatives thereof, triazole, derivatives thereof, oxazole, derivatives thereof, oxadiazole, derivatives thereof, imidazole, derivatives thereof, fluorene, derivatives thereof, polyarylalkane, derivatives thereof, pyrazoline, derivatives thereof, pyrazolone, derivatives thereof, phenylenediamine, derivatives thereof, arylamine, derivatives thereof, starburst amine, phthalocyanine, derivatives thereof, amino-substituted chalcone, derivatives thereof, styryl anthracene, derivatives thereof, fluorenone, derivatives thereof, hydrazone, derivatives thereof, stilbene, derivatives thereof, silazane, derivatives thereof, aromatic tertiary amine compounds, styrylamine compounds, aromatic dimethylidin compounds, porphyrin compounds, polysilane compounds, poly(N-vinylcarbazole), derivatives thereof, organic silanes, derivatives thereof, polymers containing these substances; conductive metal oxides, such as vanadium oxide, tantalum oxide, tungsten oxide, molybdenum oxide, ruthenium oxide and aluminum oxide; conductive polymers and oligomers, such as polyaniline, aniline-based copolymers, thiophene oligomers, and polythiophenes; organic conductive materials, such as poly(3,4-ethylenedioxythiophene)-polystyrene sulfonic acid, and polypyrrole, and polymers containing these substances; amorphous carbon; acceptor organic compounds, such as tetracyanoquinodimethane, derivatives thereof (e.g., 2,3,5,6-tetrafluoro-7,7,8,8-tetracyanoquinodimethane), 1,4-naphthoquinone, derivatives thereof, diphenoquinone, derivatives thereof, and a polynitro compound; and silane coupling agents, such as octadecyltrimethoxysilane. These materials may be used in the form of a single component or a composition containing a plurality of components. The hole injection layer may have a single-layer structure formed only of any of these materials or a multilayer structure formed of a plurality of layers that are of an identical composition or of different compositions. The materials listed as examples of materials usable in the hole transport layer, described later, can also be used in the hole injection layer.

When organic compound layers such as the hole transport layer and the light-emitting layer are formed subsequently to the hole injection layer (in particular, when both layers are formed by a coating method), the layer applied first may be dissolved in the solvent contained in a solution for the subsequently applied layer, which may result in a failure to form a laminate structure. For such a case, a method for making the lower layer insoluble in a solvent can be used. The method for making the lower layer insoluble in a solvent includes a method in which a crosslinkable group is attached to a polymer compound to crosslink the polymer compound, thereby making the compound insoluble; a method in which a low-molecular-weight compound having an aromatic-ring-containing crosslinkable group, such as an aromatic bisazide, is mixed as a crosslinkable agent, and crosslinking is performed, thereby making the compound insoluble; a method in which a low-molecular-weight compound having a crosslinkable group that has no aromatic ring, such as an acryloyl group, is mixed as a crosslinkable agent, and crosslinking is performed, thereby making the compound insoluble; a method in which the lower layer is exposed to ultraviolet light to crosslink the layer, thereby making the lower layer insoluble in the organic solvent used in the production of the upper layer; and a method in which the lower layer is heated to crosslink the layer, thereby making the lower layer insoluble in the organic solvent used in the production of the upper layer. The temperature for heating the lower layer is typically 100°C to 300°C, and the time for heating is typically 1 minute to 1 hour. Another method for stacking layers without the lower layer being dissolved in a solvent, other than crosslinking, is to use solutions with different polarities in forming adjacent layers. For example, while a water-soluble polymer compound is used for the lower layer, an oil-soluble polymer compound is used for the upper layer so that when the upper layer is applied, the lower layer does not become dissolved in the solvent of the upper layer.

The optimum value of the thickness of the hole injecting layer varies depending on the material for use, and may be selected such that the drive voltage and the current efficiency have appropriate values. The hole injecting layer must have a thickness that can deter pinholes. An overly large thickness is not preferable because such a device may have a high drive voltage. Thus, the thickness of the hole injection layer is typically 1 nm to 1 µm, preferably 2 nm to 500 nm, and more preferably 10 nm to 100 nm.

### Hole Transport Layer

Examples of materials that constitute the hole transport layer in the light-emitting device according to this embodiment include carbazole, derivatives thereof, triazole, derivatives thereof, oxazole, derivatives thereof, oxadiazole, derivatives thereof, imidazole, derivatives thereof, fluorene, derivatives thereof, polyarylalkane, derivatives thereof, pyrazoline, derivatives thereof, pyrazolone, derivatives thereof, phenylenediamine, derivatives thereof, arylamine, derivatives thereof, amino-substituted chalcone, derivatives thereof, styryl anthracene, derivatives thereof, fluorenone, derivatives thereof, hydrazone, derivatives thereof, stilbene, derivatives thereof, silazane, derivatives thereof, aromatic tertiary amine compounds, styrylamine compounds, aromatic dimethylidin compounds, porphyrin compounds, polysilane compounds, poly(N-vinylcarbazole), derivatives thereof, organosilanes, derivatives thereof, and polymers containing these structures; conductive polymers and oligomers, such as aniline copolymers, thiophene oligomers, and polythiophenes; and organic conductive materials, such as polypyrrole. These materials may be a polymer compound composed of a single component or a plurality of components. The hole transport layer may have a single-layer structure composed only of any of these materials, or a multilayer structure composed of a plurality of layers of an identical composition or of different compositions. Additionally, the materials listed as examples of materials for use in the hole injection layer may also be used in the hole transport layer.

In forming an organic layer, such as the light-emitting layer, subsequently to the hole transport layer, by a coating method, if the lower layer is dissolved in the solvent contained in a solution for the subsequently applied layer, the lower layer can be made insoluble in the solvent in the same manner as in the examples described for the method for forming the hole injection layer.

The optimum value of the thickness of the hole transport layer varies depending on the material for use, and may be selected such that the drive voltage and the current efficiency have appropriate values. The hole transport layer must have a thickness that can deter pinholes. An overly large thickness is not preferable because such a device may have a high drive voltage. Thus, the thickness of the hole transport layer is typically 1 nm to 1 µm, preferably 2 nm to 500 nm, and more preferably 5 nm to 100 nm.

The material for use in the hole transport layer may be luminescent materials listed as examples for the light-emitting layer, materials formed by attaching a crosslinkable group to a luminescent material, or the like materials.

Examples of preferable layer structures of the light-emitting device according to this embodiment include the following:
(a) anode/light-emitting layer/electron transport layer/cathode
(b) anode/hole injection layer/light-emitting layer/electron transport layer/cathode
(c) anode/hole injection layer/hole transport layer/light-emitting layer/electron transport layer/cathode
(d) anode/light-emitting layer/electron transport layer/electron injection layer/cathode
(e) anode/hole injection layer/light-emitting layer/electron transport layer/electron injection layer/cathode
(f) anode/hole injection layer/hole transport layer/light-emitting layer/electron transport layer/electron injection layer/cathode

From the standpoint of improving electrode adhesion and/or improving electric charge injection from an electrode, the light-emitting device according to this embodiment may include an insulated layer adjacent to one or both electrodes. However, it is preferred that the electron transport layer and the cathode be adjacent to each other. From the standpoint of, for example, improving interface adhesion and/or preventing interface mixing, a thin buffer layer may be inserted at the interface of the hole transport layer, electron transport layer, or light-emitting layer. The order of layers stacked, the number of stacked layers, and the thickness of each layer may be adjusted taking into consideration current efficiency and device lifetime.

The light-emitting device according to this embodiment can be produced, for example, by stacking the layers in sequence on a substrate. Specifically, the light-emitting device can be produced, for example, by stacking the anode on a substrate, stacking layers such as the hole injection layer and the hole transport layer thereon, stacking the light-emitting layer thereon, stacking the electron transport layer thereon, and further stacking the cathode thereon.

In another production method, the light-emitting device can be produced by stacking the cathode on a substrate, stacking layers such as the electron transport layer, the light-emitting layer, the hole transport layer, and the hole injection layer, thereon, and further stacking the anode thereon.

In still another production method, the light-emitting device can be produced by bring an anode or an anode-side substrate formed by stacking layers on the anode to a cathode or a cathode-side substrate formed by stacking layers on the cathode such that they face each other, and joining them.

Stacking layers may be performed by a vacuum deposition method or a coating method.

In this embodiment, it is preferred that at least the electron transport layer be formed by a coating method. More specifically, it is preferred that the electron transport layer be formed by preparing a composition containing the electron transport material and the particles, and applying the composition by a coating method to form a film.

The solvent for use in the coating method may be any solvent capable of dissolving or homogeneously dispersing the material used in forming the layer therein. Examples of solvents include chlorine solvents, such as 1,2-dichloroethane, 1,1,2-trichloroethane, chlorobenzene, and o-dichlorobenzene; ether solvents, such as THF, dioxane, anisole, and 4-methylanisole; aromatic hydrocarbon solvents, such as toluene, xylene, mesitylene, ethylbenzene, pentylbenzene, hexylbenzene, heptylbenzene, octylbenzene, nonylbenzene, decylbenzene, undecylbenzene, dodecylbenzenecyclohexylbenzene, trimethylbenzene, and 3-phenoxytoluene; aliphatic hydrocarbon solvents, such as cyclohexane, methylcyclohexane, n-pentane, n-hexane, n-heptane, n-octane, n-nonane, n-decane, n-dodecane, and bicyclohexyl; ketone solvents, such as acetone, methyl ethyl ketone, cyclohexanone, and acetophenone; ester solvents, such as ethyl acetate, butyl acetate, ethyl cellosolve acetate, methyl benzoate, and phenyl acetate; polyhydric alcohol solvents, such as ethylene glycol, glycerin, and 1,2-hexanediol; alcohol solvents, such as methanol, ethanol, isopropyl alcohol, 1-butanol, tert-butyl alcohol, and cyclohexanol; sulfoxide solvents, such as dimethyl sulfoxide; amide solvents, such as N-methyl-2-pyrrolidone, and N-N-dimethylformamide; fluorinated alcohol solvents, such as 2,2,3,3-tetrafluoropropanol, 1,1,1-trifluoro-2-propanol, 1,1,1,3,3,3-hexafluoro-2-propanol, 2,2,3,3,4,4-hexafluorobutanol, 2,2,3,3,4,4,4-heptafluoro-1-butanol, 2,2,3,3,3-pentafluoro-1-propanol, 3,3,4,4,5,5,5-heptafluoro-2-pentanol, 2,2,3,3,4,4,5,5-octafluoro-1-pentanol, 3,3,4,4,5,5,6,6,6-nonafluoro-1-hexanol, and 2,2,3,3,4,4,5,5,6,6,7,7-dodecafluoroheptanol; and water. These solvents may be used singly or in a combination of two or more.

When the electron transport layer is formed by a coating method, it is preferred that the particles to be contained in the electron transport layer be dispersed in the solvent used in the coating method. To increase the dispersibility in the solvent, the particles may be surface-modified.

Examples of film forming methods include coating methods such as spin coating, casting, microgravure printing, gravure printing, bar coating, roll coating, wire bar coating, dip coating, slit coating, cap coating, spray coating, screen printing, flexographic printing, offset printing, ink jet printing, and nozzle coating; slit coating or ink jet printing is preferable for use.

The amount of the solvent in the coating solution is typically 1000 to 100000 parts by mass, and preferably 2000 to 20000 parts by mass, per 100 parts by mass of the material for use in forming the layer.

The method for forming the layers other than the electron transport layer can be any method, and may be a known method. When the material for use in forming each layer is a low-molecular-weight compound, such layers can be formed, for example, by a vacuum deposition method using a powder, or a method for forming a layer from a solution or a molten material. When the material for use in forming each layer is a polymer compound, such layers can be formed, for example, by a method for forming a layer from a solution or a molten material.

The order of layers stacked, the number of stacked layers, and the thickness of each layer may be adjusted taking into consideration current efficiency and device lifetime.

To achieve planar luminescence using the light-emitting device, a planar anode and a planar cathode may be arranged such that one is placed on the top of another. Patterned luminescence can be achieved by a method in which a mask provided with patterned windows is placed on the surface of a planar light-emitting device; a method in which a layer to be a non-luminescent portion is formed extremely thick, thereby making the portion substantially non-luminescent; or a method in which the anode or the cathode, or both electrodes are formed to have a pattern. A segment display device capable of displaying numbers, characters, and the like can be obtained by forming a pattern by any of these methods and arranging some electrodes such that the electrodes can be turned ON and OFF independently. A dot-matrix display device can be obtained by forming both the anode and the cathode in a stripe shape and arranging the electrodes orthogonal to each other. A partial color display and a multicolor display can be achieved by using a method for painting a plurality of polymer compounds of different luminescent colors or a method using a color filter or a fluorescence conversion filter. A dot-matrix display device can be driven in a passive-matrix mode or in an active-matrix mode in combination with TFT, for example. These display devices can be used in displays, such as of computers, televisions, and mobile terminal devices. A planar light-emitting device can be suitably used in a planar optical source for the backlight of liquid-crystal display devices or in an optical source for planar illumination. These display devices can also be used in an optical source with a curved surface, and a display device with a curved surface by using a flexible substrate.

Although preferable embodiments of the light-emitting device according to the present invention have been described above, the present invention is not limited to these embodiments.

### Examples

The present invention is described in detailed below with reference to Examples but is not limited to these.

### NMR Measurement

In NMR measurement, a measurement sample (about 10 mg) was dissolved in a heavy solvent (about 0.7 mL), and an NMR apparatus (produced by Agilent Technologies Inc., trade name: INOVA300 or MERCURY 400VX) was used.

### TLC-MS

TLC-MS measurement was performed as follows: a measurement sample was dissolved in toluene, tetrahydrofuran, or chloroform at any concentration, the solution was applied to a TLC plate for DART (produced by Techno Applications, trade name: YSK5-100), and measurement was conducted using TLC-MS (produced by JEOL, Ltd., trade name: JMS-T100TD (AccuTOF TLC)). The temperature of helium gas during measurement was adjusted to a range of 200 to 400°C.

### HPLC Analysis

As the index of the purity of a compound, a value of the high performance liquid chromatography (HPLC) area percentage value was used. This is a value in HPLC (produced by Shimadzu Corporation, trade name: LC-20A) at 254 nm, unless otherwise specified. In this operation, a compound to be measured was dissolved in tetrahydrofuran or chloroform so as to give a concentration of 0.01 to 0.2 mass%, and 1 to 10 µL of the solution was poured into HPLC depending on the concentration. As the mobile phase of HPLC, acetonitrile and tetrahydrofuran were used and allowed to flow at a flow rate of 1 mL/min as gradient analysis of acetonitrile/tetrahydrofuran = 100/0 to 0/100 (volume ratio). SUMIPAX ODS Z-CLUE (produced by Sumika Chemical Analysis Service, Ltd.) or an ODS column having an equivalent performance was used as the column. A photo diode array detector (produced by Shimadzu Corporation, trade name: SPD-M20A) was used as the detector.

### Liquid Chromatography Mass Spectrometry

Liquid chromatography mass spectrometry (LC-MS) was performed as follows: a measurement sample was dissolved in chloroform or THF so as to give a concentration of about 2 mg/mL, and about 1 µL of the solution was poured into LC-MS (produced by Agilent Technologies Inc., trade name: 1100LCMSD). As the mobile phase of LC-MS, acetonitrile and THF were used while changing the ratio, and allowed to flow at a flow rate of 0.2 mL/min. As the column, a SUMIPAX ODS Z-CLUE (diameter: 4.6 x 250 mm, 3 µm; produced by Sumika Chemical Analysis Service, Ltd.) was used.

### Measurement of Z-Average Size

In the measurement of Z-average size, measurement sample particles were dispersed in a solvent capable of dispersing the particles to give a concentration of about 1 mass% or less, and a Zetasizer (produced by Malvern Panalytical Ltd., trade name: Zetasizer Nano ZS) was used.

### Measurement of Root Mean Square Roughness, Maximum Difference in Height, and Particle Density

The root mean square roughness, the maximum difference in height, the number of particles per unit area in an electron transport layer (in this specification, the number of particles per unit area is sometimes referred to as "particle density") were measured in the following manner.

A solution for forming an electron transport layer was formed into a film on a glass substrate, and then analysis was performed using an image obtained by measuring an area of 10 µm × 10 µm with an atomic force microscope.

### Synthesis Example 1: Synthesis of Monomer CM1 to Monomer CM6

Monomer CM1 to Monomer CM6 were synthesized according to the method described in the following literature, and those each showing an HPLC area percentage value of 99.5% or more were used.

Monomer CM1 was synthesized according to the method described in JP2012-033845A.

Monomer CM2 was synthesized according to the method described in JP2010-189630A.

Monomer CM3 to Monomer CM5 were synthesized according to the method described in WO2013/146806.

Monomer CM6 was synthesized according to the method described in WO2009/157424.

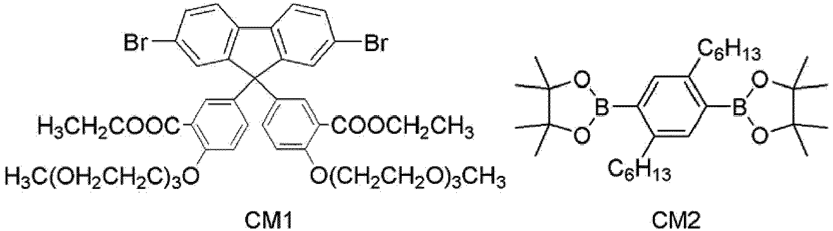

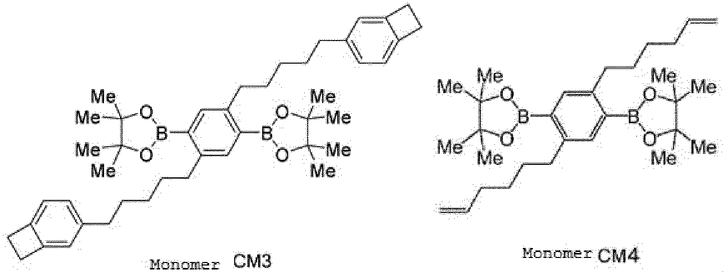

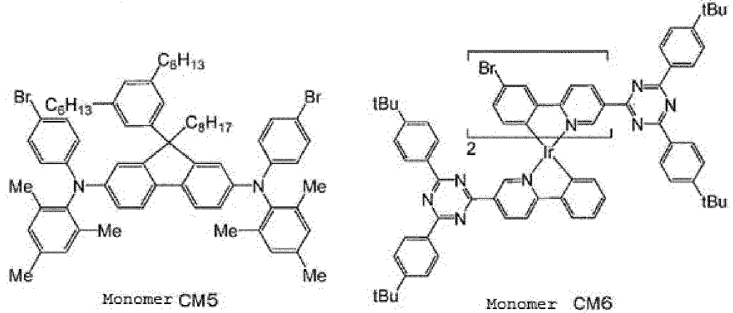

### Synthesis Example 2: Synthesis of Polymer Compound E1

An inert gas atmosphere was produced in a reaction vessel. Then, monomer CM1 (9.23 g), monomer CM2 (4.58 g), dichlorobis(tris-o-methoxyphenylphosphine)palladium (8.6 mg), and toluene (175 mL) were added and heated to 105°C. Subsequently, a 12 mass% sodium carbonate aqueous solution (40.3 mL) was added dropwise thereto, and the mixture was refluxed for 29 hours. Thereafter, phenylboronic acid (0.47 g) and dichlorobis(tris-o-methoxyphenylphosphine)palladium (8.7 mg) were added thereto, and the mixture was refluxed for 14 hours.

Thereafter, a sodium diethyldithiocarbamate aqueous solution was added thereto, followed by stirring at 80°C for 2 hours. The obtained reaction liquid was cooled, and then added dropwise to methanol, thereby forming a precipitate. The precipitate was collected by filtration, washed with methanol and water, and dried, thereby obtaining a solid. The solid was dissolved in chloroform. The solution was purified by passing through, in this order, an aluminum column and a silica gel column through which chloroform had previously passed. The obtained purified liquid was added dropwise to methanol, followed by stirring, thereby forming a precipitate. The precipitate was collected by filtration and dried to obtain polymer compound P1 (7.15 g). Mn and Mw of polymer compound P1 were respectively 3.2 × 10⁴ and 6.0 × 10⁴.

Polymer compound P1 is a copolymer comprising a constitutional unit derived from monomer CM1 and a constitutional unit derived from monomer CM2 in a molar ratio of 50:50, according to the theoretical value calculated from the amount of raw materials.

An argon gas atmosphere was produced in a reaction vessel. Then, polymer compound P1 (3.1 g), tetrahydrofuran (130 mL), methanol (66 mL), cesium hydroxide monohydrate (2.1 g) and water (12.5 mL) were added, followed by stirring at 60°C for 3 hours. Subsequently, methanol (220 mL) was added thereto, and the mixture was stirred for 2 hours. After the obtained reaction mixture was concentrated, it was added dropwise to isopropyl alcohol, followed by stirring, thereby forming a precipitate. The precipitate was collected by filtration and dried to obtain polymer compound E1 (3.5 g). ¹H-NMR analysis of polymer compound E1 confirmed that the signal at the ethyl ester site in polymer compound P1 disappeared, and the reaction was completed.

Polymer compound E1 is a copolymer comprising the constitutional unit represented by the following formula and a constitutional unit derived from monomer CM2 in a molar ratio of 50:50, according to the theoretical value calculated from the amount of raw materials of polymer compound P1.

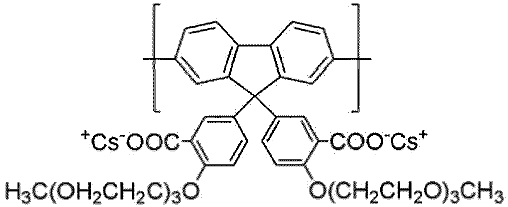

### Synthesis Example 3: Synthesis of Polymer Compound H1

An inert gas atmosphere was produced in a reaction vessel. Then, monomer CM3 (2.52 g), monomer CM4 (0.47 g), monomer CM5 (4.90 g), monomer CM6 (0.53 g), and toluene (158 mL) were added and heated to 95°C. A 20 mass% tetraethyl ammonium hydroxide aqueous solution (16 mL), and dichlorobis (tris-o-methoxyphenylphosphine) palladium (4.2 mg) were added to the reaction liquid, followed by reflux for 8 hours. After the reaction, phenylboronic acid (0.12 g), a 20 mass% tetraethylammonium hydroxide aqueous solution (16 mL), and dichlorobis(tris-o-methoxyphenylphosphine)palladium (4.2 mg) were added, and the mixture was refluxed for 15 hours. Thereafter, a sodium diethyldithiacarbamate aqueous solution was added thereto, followed by stirring at 85°C for 2 hours. After cooling, the reaction liquid was washed twice with a 3.6 mass% hydrochloric acid aqueous solution, twice with a 2.5 mass% ammonia aqueous solution, and four times with water, and the resulting solution was added dropwise to methanol, thereby forming a precipitate. The precipitate was dissolved in toluene, and purified by passing through an alumina column and a silica gel column in this order. The obtained solution was added dropwise to methanol, followed by stirring. The obtained precipitate was then collected by filtration and dried to obtain polymer compound H1 (6.02 g). Mn and Mw of polymer compound H1 measured under measurement conditions 1 were respectively 3.8 × 10⁴ and 4.5 × 10⁵.

Polymer compound H1 is a copolymer comprising a constitutional unit derived from monomer CM3, a constitutional unit derived from monomer CM4, a constitutional unit derived from monomer CM5, and a constitutional unit derived from monomer CM6 in a molar ratio of 40:10:47:3, according to the theoretical value calculated from the amount of raw materials.

### Synthesis Example 4: Synthesis of Phosphorescent Compounds 1 and 2

Phosphorescent compounds 1 and 2 were synthesized according to the method described in the following literature, and those each showing an HPLC area percentage value of 99.5% or more were used.

Phosphorescent compound 1 was synthesized in a manner similar to that of the method described in WO2006/121811.

Phosphorescent compound 2 was synthesized according to the method described in WO2009/131255.

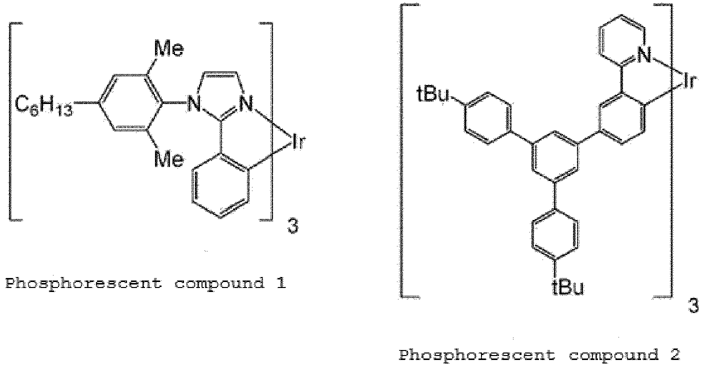

### Synthesis Example 5: Synthesis of Low-Molecular-Weight Compound E2

An inert atmosphere was produced in a flask. 8.7 g (0.022 mol) of 2,8-dibromo-4-butyldibenzothiophene and 8.1 g (0.048 mol) of 4-aza-1H-carbazole were dissolved in 218 mL of dimethyl sulfoxide. After 1.3 g (0.009 mol) of Cu₂O and 16.7 g (0.079 mol) of tripotassium phosphate were added thereto, 3.2 g (0.018 mol) of dipivaloylmethane was added, and the mixture was heated in an oil bath at 150°C.

After the reaction liquid was allowed to cool, 87 mL of toluene and 87 mL of water were added, and the mixture was filtered through a glass filter covered with Celite 545, followed by separation and washing. The obtained organic phase was concentrated, and purified by passing through a silica gel column, then activated carbon, and finally Celite 545. The solvent of the obtained solution was distilled off, followed by drying under reduced pressure with a vacuum dryer at 50°C for 12 hours or more, to obtain 9.4 g of low-molecular-weight compound E2.

### Example 1: Production and Evaluation of Light-Emitting Device D1 (i) Formation of Anode and Hole Injection Layer

An anode was formed by applying an ITO film with a thickness of 45 nm to a glass substrate by a sputtering method. On the anode, a hole injection material (ND-3202) produced by Nissan Chemical Industries, Ltd., was formed into a film having a thickness of 35 nm by a spin coating method. The substrate on which the hole injection material was formed into a film was heated on a hot plate at 50°C for 3 minutes to evaporate the solvent, and then heated on the hot plate at 240°C for 15 minutes, thus forming a hole injection layer.

### (ii) Formation of Hole Transport Layer

Polymer compound H1 was dissolved in xylene at a concentration of 0.65 mass%. Using the obtained xylene solution, a film was formed to a thickness of 20 nm on the hole injection layer by the spin coating method, and heated in a nitrogen gas atmosphere on the hot plate at 180°C for 60 minutes, thus forming a hole transport layer.

### (iii) Formation of Light-Emitting Layer

Low-molecular-weight compound 1 represented by the following formula:

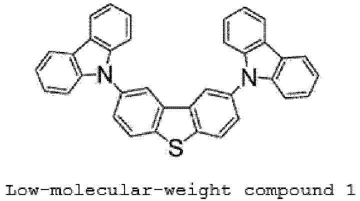

(LT-N4013 produced by Luminescence Technology Corp.), phosphorescent compound 1, and phosphorescent compound 2 (mass ratio: low-molecular-weight compound 1/phosphorescent compound 1/phosphorescent compound 2 = 74/25/1) were dissolved in toluene at a concentration of 2.0 mass% to prepare a toluene solution. Using this toluene solution, a film was formed on the hole transport layer to a thickness of 75 nm by the spin coating method, and a light-emitting layer was formed by heating at 130°C for 10 minutes in a nitrogen gas atmosphere.

### (iv) Formation of Electron Transport Layer

0.5 parts by mass of polymer compound E1 (refractive index 1.71) was dissolved in 100 parts by mass of 2,2,3,3,4,4,5,5-octafluoro-1-pentanol, and additionally, 0.5 parts by mass of silica particles (QSG-170 produced by Shin-Etsu Chemical Co., Ltd., refractive index: 1.46, Z-average size: 199 nm) was dispersed. Using the thus obtained dispersion, a film was formed on the light-emitting layer by the spin coating method so that polymer compound E1 had a thickness of 20 nm, and heated in a nitrogen gas atmosphere at 130°C for 10 minutes, thus forming an electron transport layer. In this electron transport layer, the mass of particles relative to 100 parts by mass of polymer compound E1, which is an electron transport material, is 100 parts by mass.

### (v) Formation of Cathode

The substrate on which the electron transport layer was formed was placed in a vapor deposition machine, and the pressure was reduced to 1.0 × 10^{-4Pa} or less. Subsequently, as the cathode, about 4 nm of sodium fluoride was vapor-deposited on the electron transport layer, and then about 100 nm of aluminum was vapor-deposited on it. Thereafter, sealing was performed using a glass substrate to produce light-emitting device D1. In the obtained light-emitting device D1, the number of silica particles per unit area was 2.3/µm². The root mean square roughness at the interface between the cathode or the electron injection layer and the electron transport layer was 38.3 nm.

### Comparative Example 1: Production and Evaluation of Light-Emitting Device CD1

Light-emitting device CD1 was produced in the same manner as in Example 1, except that silica particles were not added to the electron transport layer. In obtained light-emitting device CD1, the number of particles per unit area was 0/µm². The root mean square roughness at the interface between the cathode or the electron injection layer and the electron transport layer was 1 nm or less.

### Example 2: Production and Evaluation of Light-Emitting Device D2

Light-emitting device D2 was produced in the same manner as in Example 1, except that 4 nm of sodium fluoride was vapor-deposited on the electron transport layer, then about 1 nm of magnesium was vapor-deposited on it, and about 100 nm of aluminum was vapor-deposited on it in place of vapor-depositing about 4 nm of sodium fluoride on the electron transport layer and then about 100 nm of aluminum on it as the cathode. In light-emitting device D2, the number of silica particles per unit area and the root mean square roughness at the interface between the cathode or the electron injection layer and the electron transport layer were the same as those of Example 1.

### Comparative Example 2: Production and Evaluation of Light-Emitting Device CD2

Light-emitting device CD2 was produced in the same manner as in Example 2, except that silica particles were not added to the electron transport layer.

### Example 3: Production and Evaluation of Light-Emitting Device D3

Light-emitting device D3 was produced in the same manner as in Example 1, except that the same parts by mass of low-molecular-weight compound E2 (refractive index: about 1.70) were used in place of polymer compound E1 used for the electron transport layer. In light-emitting device D3, the number of silica particles per unit area was 1.8/µm². The root mean square roughness at the interface between the cathode or the electron injection layer and the electron transport layer was 35.8 nm.

### Comparative Example 3: Production and Evaluation of Light-Emitting Device CD3

Light-emitting device CD3 was produced in the same manner as in Example 3, except that silica particles were not added to the electron transport layer.

### Examples 4 to 11: Production of Light-Emitting Devices D4 to D11

Light-emitting devices D4 to D11 were produced in the same manner as in Example 3 except that the parts by mass of the silica particles relative to 100 parts by mass of low-molecular-weight compound E2 used for the electron transport layer were changed to those shown in Table 4.

### Comparative Example 4: Production and Evaluation of Light-Emitting Device CD4

Light-emitting device CD4 was produced in the same manner as in Example 3, except that the parts by mass of the silica particles relative to 100 parts by mass of low-molecular-weight compound E2 used for the electron transport layer were changed to 250 parts by mass.

### Example 12: Production and Evaluation of Light-Emitting Device D12

Light-emitting device D12 was produced in the same manner as in Example 3, except that silica particles (Sicastar produced by Corefront Corporation, refractive index: 1.46, mean particle size: 300 nm (catalog value) according to the dynamic light scattering method) were used in place of silica particles (QSG-170 produced by Shin-Etsu Chemical Co., Ltd., refractive index: 1.46, Z-average size: 199 nm) used for the electron transport layer.

### (vi) Evaluation of Light-Emitting Device

By applying a voltage to light-emitting devices D1 to D3 and CD1 to CD3, EL emission was observed. Tables 1 to 3 show the current efficiency (cd/A) of the light-emitting device at 1000 cd/m², the electron transport material and particles used for the electron transport layer, the structure of the cathode including the electron injection layer, the refractive index difference between the refractive index of the particles and the refractive index of the electron transport layer (n1-n2).

By applying a voltage to light-emitting devices D4 to D12 and CD3 to CD4, EL emission was observed. Table 4 shows the electron transport material and particles used for the electron transport layer, Z-average size of the particles (nm), parts by mass of the particles in the electron transport layer relative to 100 parts by mass of low-molecular-weight compound E2, which is an electron transport material, the refractive index difference (n1-n2) between the refractive index of the particles and the refractive index of the electron transport layer, the current efficiency (cd/A) of the light-emitting device at 1000 cd/m², the number of silica particles per unit area (per µm²), and the root mean square roughness (RMS) at the interface between the cathode or the electron injection layer and the electron transport layer.

**Table 1**

| | Light-emitting device | Electron transport material | Particles | Electron injection layer/first cathode layer | n1-n2 | Current efficiency (cd/A) |
|---|---|---|---|---|---|---|
| Example 1 | D1 | Polymer compound E1 | Silica particles | NaF/Al | -0.25 | 41.7 |
| Comparative Example 1 | CD1 | Polymer compound E1 | None | NaF/Al | 0 | 37.1 |

As is clear from Table 1, the light-emitting device of the present invention has excellent current efficiency.

**Table 2**

| | Light-emitting device | Electron transport material | Particles | Electron injection layer/first cathode layer/second cathode layer | n1-n2 | Current efficiency (cd/A) |
|---|---|---|---|---|---|---|
| Example 2 | D2 | Polymer compound E1 | Silica particles | NaF/Mg/Ag | -0.25 | 49.1 |
| Comparative Example 2 | CD2 | Polymer compound E1 | None | Naf/Mg/Ag | 0 | 39.6 |

As is clear from Table 2, the light-emitting device of the present invention has excellent current efficiency.

**Table 3**

| | Light-emitting device | Electron transport material | Particles | Electron injection layer/first cathode layer | n1-n2 | Current efficiency (cd/A) |
|---|---|---|---|---|---|---|
| Example 3 | D3 | Low-molecular-weight compound E2 | Silica particles | NaF/Al | -0.24 | 30.9 |
| Comparative Example 3 | CD3 | Low-molecular-weight compound E2 | None | Naf/Al | 0 | 27.8 |

As is clear from Table 3, the light-emitting device of the present invention has excellent current efficiency.

**Table 4**

| | Light-emitting device | Electron transport material | Particles | average size (nm) | Parts by mass* | n1-n2 | Current efficiency (cd/A) | Per µm² | RMS (nm) |
|---|---|---|---|---|---|---|---|---|---|
| Comparative Example 3 | CD3 | Low-molecular-weight compound E2 | None | None | 0 | 0 | 27.8 | 0 | 0.4 |
| Example 4 | D4 | Low-molecular-weight compound E2 | Silica particles | 199 | 5 | -0.24 | 36.3 | 0.12 | 10.5 |
| Example 5 | D5 | Low-molecular-weight compound E2 | Silica particles | 199 | 10 | -0.24 | 36.9 | 0.18 | 13.5 |
| Example 6 | D6 | Low-molecular-weight compound E2 | Silica particles | 199 | 30 | -0.24 | 35.9 | 0.54 | 21.7 |
| Example 7 | D7 | Low-molecular-weight compound E2 | Silica particles | 199 | 50 | -0.24 | 32.4 | 1 | 30.5 |
| Example 8 | D8 | Low-molecular-weight compound E2 | Silica particles | 199 | 120 | -0.24 | 31.7 | 1.98 | 45.2 |
| Example 9 | D9 | Low-molecular-weight compound E2 | Silica particles | 199 | 150 | -0.24 | 30.3 | 2.23 | 50.8 |
| Example 10 | D10 | Low-molecular-weight compound E2 | Silica particles | 199 | 180 | -0.24 | 29.5 | 2.41 | 56.5 |
| Example 11 | D11 | Low-molecular-weight compound E2 | Silica particles | 199 | 200 | -0.24 | 30.6 | 2.35 | 55.6 |
| Comparative Example 4 | CD4 | Low-molecular-weight compound E2 | Silica particles | 199 | 250 | -0.24 | 25.2 | 1.99 | 60.4 |
| Example 12 | D12 | Low-molecular-weight compound E2 | Silica particles | 300 | 100 | -0.24 | 34.9 | 0.19 | 69.3 |

| | | | | | | | | | |
|---|---|---|---|---|---|---|---|---|---|
| * Parts by mass= parts by mass of the particles in the electron transport layer relative to 100 parts by mass of low-molecular-weight compound E2, which is an electron transport material. | | | | | | | | | |

As is clear from Table 4, the light-emitting devices of the present invention have excellent current efficiency.

### Industrial Applicability

According to the present invention, a light-emitting device that emits light with high efficiency can be obtained.

## Claims

1. A light-emitting device comprising, in sequence, a cathode, an electron transport layer, a light-emitting layer, and an anode,
the light-emitting device further optionally comprising an electron injection layer between the cathode and the electron transport layer,
wherein
the electron transport layer contains particles and a non-particle electron transport material,
a refractive index of light n1 at a wavelength of 550 nm of a material that constitutes the particles and a refractive index of light n2 at a wavelength of 550 nm of the non-particle electron transport material satisfy the following relation: n1-n2≤0.15, and
the particles have a Z-average size of 110 to 300 nm as determined by dynamic light scattering.

2. The light-emitting device according to claim 1, wherein the refractive index of light n1 at a wavelength of 550 nm of the material that constitutes the particles is 1.5 or less.

3. The light-emitting device according to claim 1 or 2, wherein the particles are silica particles.

4. The light-emitting device according to any one of claims 1 to 3, wherein the electron transport material contains a polymer compound that has a constitutional unit represented by formula (ET-1): 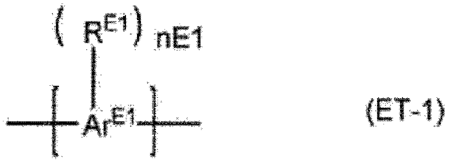
wherein nE1 represents an integer of 1 or more,
Ar^{E1} represents an optionally substituted aromatic hydrocarbon group or an optionally substituted heterocyclic group,
R^{E1} represents an optionally substituted monovalent group containing one or more heteroatoms, and when a plurality of R^{E1}s are present, the plurality of R^{E1}s may be identical or different.

5. The light-emitting device according to any one of claims 1 to 4, wherein the electron transport material contains a compound represented by formula (H-1): 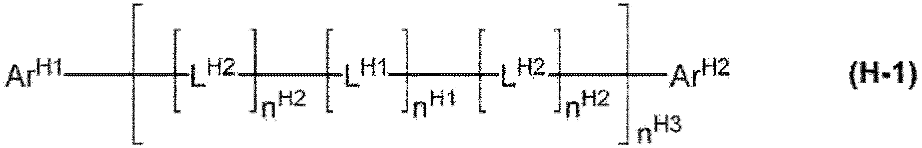
wherein Ar^{H1} and Ar^{H2} each independently represent an optionally substituted monovalent aromatic hydrocarbon group or an optionally substituted monovalent heterocyclic group,
L^{H1} represents an optionally substituted divalent aromatic hydrocarbon group or an optionally substituted divalent heterocyclic group,
L^{H2} represents a group represented by formula: -N(-L^{H21}-R^{H21})-
wherein L^{H21} represents a single bond, an optionally substituted arylene group, or an optionally substituted divalent heterocyclic group,
R^{H21} represents a hydrogen atom, an optionally substituted alkyl group, an optionally substituted cycloalkyl group, an optionally substituted aryl group, or an optionally substituted monovalent heterocyclic group,
when a plurality of L^{H1}s are present, the plurality of L^{H1}s may be identical or different,
when a plurality of L^{H2}s are present, the plurality of L^{H2}s may be identical or different, and
n^{H1}, n^{H2}, and n^{H3} each independently represent an integer of 0 or more and 10 or less.

6. The light-emitting device according to any one of claims 1 to 5, wherein the proportion of the particles is 1 to 200 parts by mass relative to 100 parts by mass of the electron transport material.

7. The light-emitting device according to any one of claims 1 to 6, wherein the number of the particles per unit area of the electron transport layer is 1/µm² or more.

8. The light-emitting device according to any one of claims 1 to 7, wherein the cathode or the electron injection layer is adjacent to the electron transport layer, and an interface between the cathode or the electron injection layer and the electron transport layer has a root mean square roughness of 5 nm or more.
